(19) **Europäisches Patentamt / European Patent Office / Office européen des brevets**

(11) **EP 4 718 754 A1**

(12) **EUROPEAN PATENT APPLICATION**
published in accordance with Art. 153(4) EPC

(43) Date of publication:
**01.04.2026 Bulletin 2026/14**

(21) Application number: **24809968.1**

(22) Date of filing: **05.02.2024**

(51) International Patent Classification (IPC):
**H04L 1/00** *(2006.01)*

(52) Cooperative Patent Classification (CPC):
**H04L 1/00**

(86) International application number:
**PCT/CN2024/076003**

(87) International publication number:
**WO 2024/239718 (28.11.2024 Gazette 2024/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.05.2023 CN 202310583794**

(71) Applicant: **ZTE Corporation**
**Shenzhen, Guangdong 518057 (CN)**

(72) Inventors:
- **MU, Lin**
  **Shenzhen, Guangdong 518057 (CN)**
- **LI, Liguang**
  **Shenzhen, Guangdong 518057 (CN)**
- **XU, Jin**
  **Shenzhen, Guangdong 518057 (CN)**
- **LIANG, Chulong**
  **Shenzhen, Guangdong 518057 (CN)**
- **ZHAO, Wei**
  **Shenzhen, Guangdong 518057 (CN)**
- **YU, Guanghui**
  **Shenzhen, Guangdong 518057 (CN)**
- **FU, Qiang**
  **Shenzhen, Guangdong 518057 (CN)**
- **KANG, Jian**
  **Shenzhen, Guangdong 518057 (CN)**

(74) Representative: **Ziebig Hengelhaupt Intellectual Property Attorneys**
**Patentanwaltskanzlei PartGmbB**
**Leipziger Straße 49**
**10117 Berlin (DE)**

(54) **ENCODING/DECODING METHOD, COMMUNICATION APPARATUS, AND STORAGE MEDIUM**

(57) Provided in embodiments of the present application are an encoding/decoding method, a communication apparatus, and a storage medium, which relate to the technical field of communications and are used for reducing the complexity of convolutional encoding. The encoding method specifically comprises: firstly acquiring an information bit sequence; then generating a polynomial according to T component codes to perform convolutional encoding on the information bit sequence to obtain an encoded bit sequence, T being an integer greater than 1; and sending all or some of the bits in the encoded bit sequence.

FIG. 2

## Description

This application claims priority of Chinese Patent Application No. 202310583794.8, filed on May 22, 2023, which is incorporated into this application by reference in its entirety.

## TECHNICAL FIELD

The present disclosure relates to the field of communication technologies, and in particular, to an encoding and decoding method, a communication apparatus, and a storage medium.

## BACKGROUND

With the rapid development of technologies such as big data, cloud computing, latency-sensitive networks, a number of user equipment in a wireless communication network is growing explosively and the wireless communication network will carry a variety of applications and massive data, thereby putting high requirements on data transmission rate, throughput, reliability, latency and the like. Currently, with the development of intelligent transportation, intelligent industrial control, intelligent logistics, the requirements for communication with ultra-low latency and ultra-high reliability is becoming increasingly urgent, and some short-packet data are required to be sent and successfully received within an extremely short time.

However, the channel encoding of short packets is complex at present, and how to further reduce the complexity of channel encoding and decoding of short packets is an urgent problem to be solved in the industry.

## SUMMARY

The present disclosure provides an encoding and decoding method, a communication apparatus, and a storage medium, for reducing the complexity of convolutional encoding.

In order to achieve the objectives mentioned above, the present disclosure adopts the following technical solutions.

In a first aspect, an encoding method is provided. The method specifically includes:

acquiring an information bit sequence;
performing, according to T component code generator polynomials, convolutional encoding on the information bit sequence, to obtain an encoded bit sequence, T being an integer greater than 1; and
sending all or some of bits in the encoded bit sequence.

In a second aspect, a decoding method is provided. The method includes:

receiving all or some of bits in an encoded bit sequence; and
performing, according to T component code generator polynomials, convolutional decoding on the all or some of the bits in the encoded bit sequence, to obtain an information bit sequence.

In a third aspect, an encoding device is provided. The encoding device includes:

an acquiring module, configured to obtain an information bit sequence;
a processing module, configured to perform convolutional encoding on the information bit sequence according to T component code generator polynomials, so as to obtain an encoded bit sequence, T being an integer greater than 1; and
a sending module, configured to send all or some of bits in the encoded bit sequence.

In a fourth aspect, a decoding device is provided. The decoding device is located at a second node and includes:

a receiving module, configured to receive all or some of bits in an encoded bit sequence; and
a processing module, configured to perform convolutional decoding on all or some of the bits in the encoded bit sequence according to T component code generator polynomials, so as to obtain an information bit sequence.

In a fifth aspect, a communication apparatus is provided. The communication apparatus includes: a processor and a memory. The memory stores instructions executable by the processor. The processor is configured to execute the instructions to enable the communication apparatus to achieve the method provided in the first aspect or the second aspect.

In a sixth aspect, a computer-readable storage medium is provided. The computer-readable storage medium has stored computer instructions. When the computer instructions are run on a computer, enable the computer to perform the method provided in the first aspect or the second aspect.

In a seventh aspect, a computer program product including computer instructions is provided. When the computer instructions are run on a computer, enable the computer to perform the method provided in the first aspect or the second aspect.

Based on the embodiments mentioned above, the method may perform convolutional encoding on an information bit sequence according to preset component code generator polynomials, thereby obtaining a bit sequence to be transmitted. The present disclosure further provides a plurality of possible implementations of preset component code generator polynomials with different convolutional encoding constraint lengths. Furthermore, since the number of non-zero coefficients in the component code generator polynomials provided in the present disclosure is small, the weight of the component code is reduced and the number of exclusive-OR (XOR) gates is also reduced by using the component code generator polynomials provided in the embodiments of the present disclosure for convolutional encoding, so that the complexity of convolutional encoding may be reduced and the robustness of data communication may be increased.

BRIEF DESCRIPTION OF THE DRAWINGS

The accompanying drawings are used for a further understanding of the technical solution of the present disclosure, constitute a part of the specification, are used to explain the technical solutions of the present disclosure together with the embodiments of the present disclosure, and do not limit the technical solutions of the present disclosure.

FIG. 1 is a schematic diagram showing an architecture of a communication system provided in embodiments of the present disclosure;

FIG. 2 is a flow chart of an encoding method provided in embodiments of the present disclosure;

FIG. 3 is a schematic diagram showing a convolutional encoding process provided in embodiments of the present disclosure;

FIG. 4 is a schematic diagram showing another convolutional encoding process provided in embodiments of the present disclosure;

FIG. 5 is a flow chart of a decoding method provided in embodiments of the present disclosure;

FIG. 6 is a schematic diagram showing a structure of an encoding device provided in embodiments of the present disclosure;

FIG. 7 is a schematic diagram showing a structure of a decoding device provided in embodiments of the present disclosure; and

FIG. 8 is a schematic diagram showing a structure of a communication apparatus provided in embodiments of the present disclosure.

DETAILED DESCRIPTION

The technical solutions in the embodiments of the present disclosure will be described clearly and completely with reference to the accompanying drawings in the embodiments of the present disclosure. However, the described embodiments are merely some but not all of embodiments of the present disclosure. All other embodiments obtained based on the embodiments of the present disclosure by a person of ordinary skill in the art without paying any creative effort shall be included in the protection scope of the present disclosure.

In the description of the present disclosure, unless otherwise specified, the symbol "/" means "or", for example, "A/B" may mean A or B. Herein, "and/or" is merely an associated relationship for describing associated objects, which means that there may be three relationships. For example, A and/or B may mean: only A, A and B at the same time, and only B. In addition, "at least one" means one or more, and "a/the plurality of" means two or more. The words, such as "first" and "second", do not limit the quantity and execution order, and do not necessarily limit existence of a difference between a first item and a second item.

It will be noted, in the present disclosure, the term such as "exemplary" or "for example" is used to represent an example, illustration, or explanation. Any embodiment or design solution described herein with "exemplary" or "for example" in the present disclosure is not necessarily to be construed as preferred or advantageous over other embodiments or design solutions Rather, the use of the term such as "exemplary" or "for example" is intended to present relevant concepts in a specific manner.

In a wireless communication system, a transmitting end performs channel encoding on to-be-transmitted data to obtain an encoded bit sequence, and then maps the encoded bit sequence into a constellation modulation symbol and sends the constellation modulation symbol to a receiving end. In a data transmission channel, errors may occur in the data transmission due to factors such as multipath, noise, and interference. The transmitting end adds some redundant information to the to-be-transmitted data by means of channel encoding. The receiving end may restore the original data to be transmitted through this redundant information, that is, eliminate the distortion caused by the data transmission. The receiving end needs to perform channel decoding on the received constellation modulation symbol, so as to recover the to-be-transmitted data.

Currently, commonly used channel encoding methods may include low density parity check encoding, polar encoding, and convolutional encoding. The low density parity check encoding is defined by a sparse (or low density) parity check matrix, and decoding performance may be improved by iterative decoding, such as belief propagation decoding; the encoding end needs to store the check matrix and perform a large number of XOR operations, which is complex. The polar encoding is a linear block code based on the channel polarization theory and theoretically proved that it may reach the Shannon limit in a case where a code length is infinite, and the polar encoding generally uses a successive cancellation list (SCL) decoding algorithm; the encoding end still needs to perform a large number of XOR operations and rate-matched operations, resulting in a high complexity. The convolutional encoding groups input information bits into information groups consisting of one or more bits, encoded output bits of each information group are related not only to the information bits of the group at the current moment, but also to the information bits of other groups at previous moments.

Therefore, in order to further reduce the complexity of channel encoding and decoding, an encoding method is provided in embodiments of the present disclosure. The method specifically includes: first acquiring an information bit sequence, then performing convolutional encoding on the information bit sequence to obtain an encoded bit sequence according to T component code generator polynomials, T being an integer greater than 1, and next sending all or some of bits in the encoded bit sequence. In this way, the complexity of convolutional encoding may be reduced.

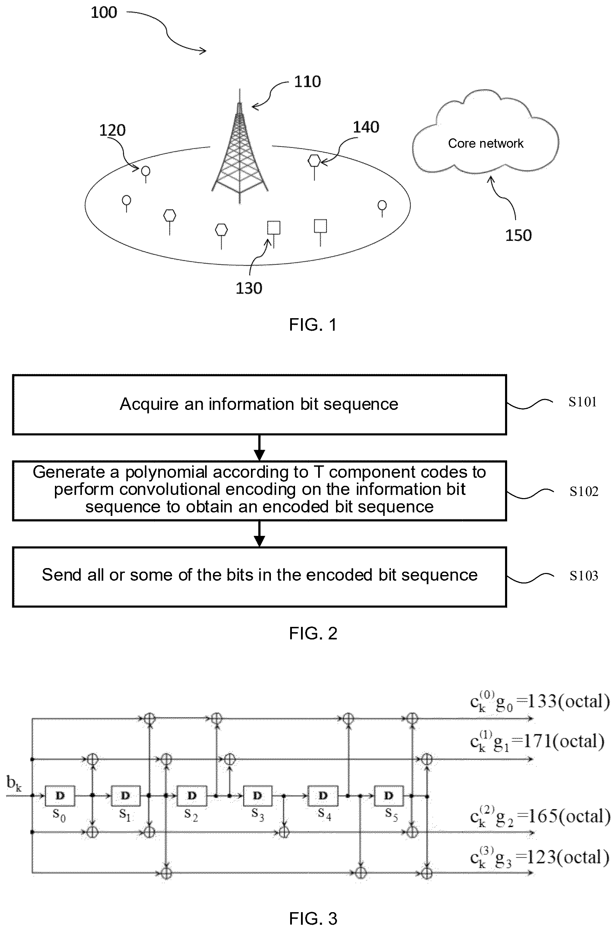

The method provided in the embodiments of the present disclosure may be applied to various communication systems. For example, the communication system may be a long term evolution (LTE) system, a 5th generation (5G) communication system, a Wi-Fi system, a communication system related to the 3rd generation partnership project (3GPP), a future evolved communication system (e.g., a 6th generation (6G) communication system), or a system integrating multiple systems, and the present disclosure is not limited thereto. The method provided in the embodiments of the present disclosure will be described below by considering the communication system 100 shown in FIG. 1 as an example. FIG. 1 is merely a schematic diagram and does not limit the applicable scenarios of the technical solutions provided in the present disclosure.

FIG. 1 is a schematic diagram showing an architecture of a communication system provided in embodiments of the present disclosure. As shown in FIG. 1, the communication system 100 may include one or more network devices and one or more terminal devices. As shown in FIG. 1, the communication system 100 may include a network device 110, a terminal device 120, a terminal device 130, a terminal device 140 and a core network 150.

The network device 110 may provide communication services for the terminal device 120, the terminal device 130, and the terminal device 140, and the network device 110 may also communicate with the core network 150.

In some embodiments, the core network may provide functions such as access authorization, user authentication, Internet Protocol (IP) connectivity, tracking, and other access, routing, or mobility management. The core network may be an access and mobility management function (AMF) entity having functions such as access control, mobility management, attachment and detachment, and gateway selection. Alternatively, the core network device is a user plane function (UPF) entity having functions such as data routing/forwarding and quality of service (QoS) flow processing. It will be noted that the core network device may also be other core network devices, and present disclosure is not specifically limited thereto.

In some embodiments, the network device may be used to achieve functions of the terminal devices, such as resource scheduling, wireless resource management, and wireless access control. For example, the network device may be a base station transceiver, a wireless base station, a wireless transceiver, a small base station, a wireless access point, a transmission receive point (TRP), a transmission point (TP), an evolved node B (eNB), a home node B, a home evolved node B, a reader-writer, and any node of some other access nodes. In some embodiments, the communication system 100 may further include different types of base stations, such as a macro cell base station and/or a small cell base station.

The terminal device may also be referred to as a terminal, user equipment (UE), a mobile station, or a mobile terminal. The terminal device may be an Internet of Things (IoT) device used to collect various information, and then send data to the base station after performing forward error correction encoding on the data information. The terminal device may be mobile devices such as a mobile phone, a tablet computer, a computer with a wireless transceiver function, a vehicle, or a new energy automobile. In addition, the terminal device may be either fixed or mobile. Various terminal devices may further include or be referred to by those skilled in the art as mobile stations, user stations, mobile units, user units, wireless units, remote units, mobile devices, wireless devices, wireless communication devices, remote devices, mobile user stations, access terminals, mobile terminals, wireless terminals, remote terminals, hand-held devices, user agents, mobile clients, clients, passive tags, or some other possible devices. Furthermore, various UEs may further include cellular phones, personal digital assistants (PDAs), wireless modems, wireless communication devices, hand-held devices, tablet computers, laptop computers, cordless phones, wireless local loop (WLL) stations, or the like. Various UEs may communicate with various base stations and network devices (including macro eNBs, small cell eNBs, relay base stations). The wireless communication system 100 may further include an IoT system or be a part of the IoT system.

It will be noted that FIG. 1 is only an exemplary architecture diagram, and the number of nodes and the names of the devices included in FIG. 1 are not limited. Moreover, in addition to the functional nodes shown in FIG. 1, the communication system may further include other nodes.

It will be noted that the communication system shown in FIG. 1 is only for the purpose of more clearly describing the technical solutions of the present disclosure and does not constitute a limitation on the present disclosure. A person skilled in the art will know that with the evolution of network architecture and the emergence of new business scenarios, the technical solutions provided in the present disclosure are also applicable to similar technical problems.

The embodiments provided in the present disclosure will be described in detail below with reference to the accompanying drawings.

As shown in FIG. 2, an encoding method is provided in the embodiments of the present disclosure. The method includes the following steps.

In S101, an information bit sequence is acquired.

The information bit sequence may be a sequence of information bits to be sent by a transmitting end, that is, a sequence of bits to be encoded by the transmitting end. The information bit refers to a bit used to carry information. For example, the information bit sequence may be expressed as $b_0$, $b_1$, $b_2$, $b_3$, ..., $b_{K-1}$, K is a length of the information bit sequence and is an integer greater than 0.

Considering the communication system 100 shown in FIG. 1 as an example, the transmitting end may be the terminal device or the network device in the communication system 100. During the communication process, if the network device sends data to the terminal device and the terminal device receives the data sent by the network device, the network device may be referred to as a transmitting end. Correspondingly, the terminal device may be referred to as a receiving end.

In S102, convolutional encoding is performed on the information bit sequence according to T component code generator polynomials, so as to obtain an encoded bit sequence.

T is an integer greater than 1. For example, a value of T includes 2, 3, 4, 6, 8, 10 or 12.

In some embodiments, the convolutional encoding is achieved by a plurality of shift registers and a plurality of XOR gates. Every two adjacent shift registers of the plurality of shift registers are connected in series. Furthermore, any one of component code output bit sequences is obtained by performing an XOR operation on input bits and bits of some shift registers.

For example, the convolutional encoding process based on the plurality of shift registers and the plurality of XOR gates is described below.

During the convolutional encoding process, at the zero-th clock tick, the transmitting end may perform encoding to obtain T bits according to the T component code generator polynomials, the data stored in the shift registers, and the zero-th bit (i.e., the current input bit) of the information bit sequence. Each shift register stores only one bit.

At the 1st clock tick, the bit data of the zero-th shift register is stored in the 1st shift register, the bit data of the 1st shift register is stored in the 2nd shift register, and so on, the bit data of the (m-2)-th shift register is stored in the (m-1)-th shift register, and the zero-th bit of the information bit sequence is stored in the zero-th shift register. Furthermore, the transmitting end may perform encoding to obtain T bits according to the adjusted data stored in the shift registers, the T component code generator polynomials and the first bit of the information bit sequence, and may further use the T bits as the output result of the 1st clock tick.

Considering the encoding operation of the 1st clock tick as an example, the encoding operations of the 2nd, 3rd, 4th, ..., clock ticks are performed in sequence until the (K-1)-th clock tick. K is a length of the information bit sequence, and an encoded bit sequence whose length is a product of K and T (i.e., K*T) may be obtained.

In some embodiments, the number of shift registers is determined according to the highest degree of the T component code generator polynomials. For example, if the highest degree of the component code generator polynomials is equal to 6, the number of shift registers is equal to 6.

In some embodiments, the number of XOR gates is determined according to the number of coefficients of the T component code generator polynomials. It will be understood that the more coefficients of the T component code generator polynomials there are, the more XOR gates there will be, and thus the higher the complexity of the convolutional encoder will be. Correspondingly, the less coefficients of the T component code generator polynomials there are, the less XOR gates there will be, and thus the lower the complexity of the convolutional encoder there will be.

In some embodiments, the weight of the component code is determined according to the number of "1"s in the component code generator vector, that is, the number of non-zero coefficients in the T component code generator polynomials. Moreover, the greater the weight of the component code, the higher the complexity of the convolutional encoder. The less the weight of the component code, the lower the complexity of the convolutional encoder.

In some embodiments, a constraint length of the convolutional encoding is determined according to the highest degree of polynomials of the T component code generator polynomials. For example, the constraint length of the convolutional encoding may be a sum of 1 and the highest degree of the polynomials of the T component code generator polynomials.

In some embodiments, the constraint length of the convolutional encoding may be at least one of: 5, 6, 7, 8, 9, 10, or 11. In an example, the constraint lengths of the convolutional encoding are 7 and 9. In another example, the constraint lengths of the convolutional encoding are 5 and 9. In yet another example, the constraint lengths of the convolutional encoding are equal to 7 and 11. In yet another example, the constraint lengths of the convolutional encoding are 7, 9, and 11.

In a possible implementation, the transmitting end may perform the convolutional encoding on the information bit sequence according to the T component code generator polynomials, so as to obtain T component code bit sequences obtained by the T component code generator polynomials. Then, the transmitting end performs an interleaving process on all or some of the T component code bit sequences, to obtain the encoded bit sequence.

In another possible implementation, the transmitting end may perform the convolutional encoding on the information bit sequence according to the T component code generator polynomials, so as to obtain T component code bit sequences obtained by the T component code generator polynomials. Then, the transmitting end performs sub-block interleaving on the i-th component code bit sequence to obtain a sub-block interleaved output sequence, and i is a non-negative integer less than T. The transmitting end determines the encoded bit sequence according to the sub-block interleaved output sequence and other component code bit sequences among the T component code bit sequences except the i-th component code bit sequence. In some embodiments, a value of i is determined according to one or more of: a number of component codes, a coding rate, a total number of transmitted bits, a number of resources, a modulation order, and a length of the information bit sequence.

**For** example, this implementation may be specifically achieved in the following steps S1 to S4.

In S1, convolutional encoding is performed on an input information bit sequence according to T component code generator polynomials, so as to obtain T component code output bit sequences.

A length of each component code output bit sequence is equal to K. Moreover, the information bit sequence may be expressed as $b_0$, $b_1$, $b_2$, $b_3$, ..., $b_{K-1}$, and K is a length of the information bit sequence.

In S2, sub-block interleaving is performed on the i-th component code bit sequence to obtain a sub-block interleaved output sequence.

Herein, i is a non-negative integer less than T. A value of i is determined according to one or more of: a number of component codes, a length of a component code output bit sequence, a coding rate, a total number of transmitted bits, a number of resources, a modulation order, and a length of the information bit sequence. For example, i is determined according to the following parameters: the number of component codes and the coding rate. For example, i may be equal to mod(floor(1/R), T). R is the coding rate and a real number greater than 0, and T is the number of component codes and a positive integer. For example, i is determined according to the following parameters: the number of component codes, the length of the component code output bit sequence, and the total number of transmitted bits. For example, i may be equal to mod(floor(E/M), T). E is the total number of transmitted bits and a positive integer, M is the length of the component code output bit sequence and a positive integer, and T is the number of component codes and a positive integer.

In an example, sub-block interleaving is performed on the i-th component code output bit sequence. Assume that the i-th component code output bit sequence input to the sub-block interleaving is $d_0^{(i)}$, $d_1^{(i)}$, $d_2^{(i)}$, ..., $d_{K-1}^{(i)}$, and with a length of K. In some embodiments, the sub-block interleaving mentioned above is achieved by using a matrix interleaver. The number of columns C of the matrix block is equal to 32 (i.e., C = 32), and the number of rows of the matrix block is determined according to the parameter K. In some embodiments, the method for determining the number of rows R of the matrix block mentioned above is as follows: the minimum integer that meets an inequality that a product of R and C is greater than or equal to K (i.e., $(R \times C) \geq K$) is the number of rows.

For example, if $(R \times C) \geq K$, NULL bits whose quantity $L_F$ is equal to a difference between a product of R and C and K (i.e., $L_F = (R \times C) - K$) need to be filled. A sequence y may be obtained after the NULL bits are filled. A head of y is the filled NULL bits and A tail of y is an output sequence of the i-th component code, that is, the sequence y is expressed as: $y_k$ = <NULL> for k = 0, 1, ..., $L_F - 1$, and $y_{L_F+k} = d_K^{(i)}$. k is equal to 0, 1, ..., K-1.

Then, the sequence y is written into the sub-block interleaved matrix block in row order. A column permutation is performed on the sub-block interleaved matrix block according to a column permutation pattern P = [1, 17, 9, 25, 5, 21, 13, 29, 3, 19, 11, 27, 7, 23, 15, 31, 0, 16, 8, 24, 4, 20, 12, 28, 2, 18, 10, 26, 6, 22, 14, 30], and the j-th column of the permuted matrix block corresponds to the P(j)-th column of the original matrix block, and j is equal to 0, 1, 2, ..., 31. The matrix with a size of R rows and C columns after the column permutation is read sequentially starting from zero-th column. If the read data is the NULL bit, it is skipped, so as to obtain the sub-block interleaved output sequence corresponding to the i-th component code, whose length is equal to K.

In S3, the zero-th, 1st, ..., (i-1)-th, (i+1)-th, ..., (T-1)-th component code output bit sequences and the sub-block interleaved output sequence of the i-th component code are combined into a total bit sequence (i.e., the encoded bit sequence), and a length of the total bit sequence is equal to a product of T and K (i.e., T*K).

For example, the zero-th, 1st, ..., (i-1)-th, (i+1)-th, ..., (T-1)-th component code output bit sequences and the sub-block interleaved output sequence of the i-th component code are combined into the total bit sequence, and the length of the total bit sequence is equal to T*K. The (t*K)-th bit to the ((t+1)*K-1)-th bit in the total bit sequence are composed of the t-th component code output bit sequence, t is a non-negative integer less than T and not equal to i. If t is equal to i, the (t*K)-th bit to the ((t+1)*K-1)-th bit in the total bit sequence are composed of the sub-block interleaved output sequence of the i-th component code.

It will be noted that in this step, it is not necessary to perform sub-block interleaving on the t-th component code output bit sequence. In this way, it is also possible to reduce the interleaving of the convolutional encoding and the complexity of the encoding.

In S4, bit selection is performed on the encoded bit sequence to obtain a to-be-transmitted bit sequence, and send the to-be-transmitted bit sequence.

The to-be-transmitted bit sequence includes all or some of bits in the encoded bit sequence.

For example, the bit selection is performed on the encoded bit sequence to obtain the to-be-transmitted bit sequence. Cyclic selection starts from the zero-th bit in the total bit sequence, if the last bit is selected, the selection continues from the zero-th bit, if the required number of bits is obtained, the selection stops.

In some embodiments, the T component code generator polynomials may be determined from a set of preset component code generator polynomials. Furthermore, in some embodiments, all T component code generator polynomials mentioned above may further constitute another set of preset component code generator polynomials, that is, the convolutional encoding is performed by using all T component code generator polynomials in the set of preset component code generator polynomials. Several possible implementations of the set of preset component code generator polynomials are described below.

In an implementation 1, a value of the constraint length of the convolutional encoding is 7. In this case, the number of required shift registers may be a difference between 7 and 1 (i.e., 7 - 1 = 6), and the highest degree of the set of preset component code generator polynomials is 6. The set of preset component code generator polynomials includes at least one of the following component code generator polynomials:

$$g_0(D) = 1 + D^2 + D^3 + D^5 + D^6;$$

$$g_1(D) = 1 + D^1 + D^2 + D^3 + D^6;$$

$$g_2(D) = 1 + D^1 + D^2 + D^4 + D^6;$$

or

$$g_3(D) = 1 + D^2 + D^5 + D^6.$$

Octal numbers corresponding to the four component code generator polynomials are 133, 171, 165, and 123, respectively. In a case where four component code generator vectors are represented in binary, the four component code generator vectors are {1, 0, 1, 1, 0, 1, 1}, {1, 1, 1, 1, 0, 0, 1}, {1, 1, 1, 0, 1, 0, 1}, and {1, 0, 1, 0, 0, 1, 1}, respectively. It will be noted that, in the component code generator vectors represented in binary, a value of the last bit of each generator vector corresponds to a high degree of the component code generator polynomial, and a value of the first bit of each generator vector corresponds to a low degree of the component code generator polynomial. Therefore, the corresponding component code generator vector represented in binary may be determined according to the corresponding coefficients in the component code generator polynomial. It will be noted that three representation methods used herein for the convolutional encoding include: a component code generator polynomial, a component code generator vector represented in binary, and a component code generator polynomial represented in octal. The three representation methods are completely equivalent to each other. Any component code generator polynomial will have a corresponding component code generator vector represented in binary and a corresponding component code generator polynomial represented in octal. Therefore, any one of the representation methods may be used to describe the convolutional encoding. For example, only the component code generator polynomial represented in octal may be used to describe the convolutional encoding, or only the component code generator polynomial may be used to describe the convolutional encoding, or only the component code generator vector represented in binary may be used to describe the convolutional encoding.

In some embodiments, the weight of the four component codes obtained according to the component code generator polynomials mentioned above is equal to 19, and the weight of the component codes refers to the number of "1"s in the four component code generator vectors. In general, the number of "1"s in the generator vector is proportional to the number of required XOR gates. That is to say, the more "1"s there are, the more XOR gates are required and the higher the complexity is. In a case of the same performance, the fewer the number of "1"s in the generator vector, the more conducive it is to achieving the corresponding hardware, that is, the simpler it is to achieve the corresponding hardware.

If the information bit sequence is $b_0, b_1, b_2, b_3, ..., b_{K-1}$, the convolutional encoding process is shown in FIG. 3. The number of passed shift registers, that is, the number of delayed clock ticks, may be determined according to the degree of "D" in the component code generator polynomial. For example, $g_0(D) = 1 + D^2 + D^3 + D^5 + D^6$ means that the output bit of the component code corresponding to the generator polynomial is a result obtained by performing the XOR operation on the no-delay bit (1 information bit), the output of the second shift register (passing through 2 delayers and corresponding to the shift register $S_1$), the output of the third shift register (passing through 3 delayers and corresponding to the shift register $S_2$), the output of the fifth shift register (passing through 5 delayers and corresponding to the shift register $S_4$), and the output of the sixth shift register (passing through 6 delayers and corresponding to the shift register $S_5$). Similarly, $g_1(D) = 1 + D^1 + D^2 + D^3 + D^6$ means that the output bit of the component code corresponding to the generator polynomial is a result obtained by performing the XOR operation on the no-delay bit (1 information bit), the output of the first shift register (passing through 1 delayer and corresponding to the shift register S0), the output of the second shift register (passing through 2 delayers and corresponding to the shift register S1), the output of the third shift register (passing through 3 delayers and corresponding to the shift register S2), and the output of the sixth shift register (passing through 6 delayers and corresponding to the shift register $S_5$).

In an example, the set of preset component code generator polynomials includes the following component code generator polynomials: $g_0(D) = 1 + D^2 + D^3 + D^5 + D^6$; $g_1(D) = 1 + D^1 + D^2 + D^3 + D^6$; $g_2(D) = 1 + D^1 + D^2 + D^4 + D^6$; $g_3(D) = 1 + D^2 + D^5 + D^6$; and the corresponding component code generator polynomials represented in octal are: 133, 171, 165, 123, respectively. Furthermore, the component code output bit sequences corresponding to the four component code generator polynomials mentioned above are: $C^{(0)}$; $C^{(1)}$; $C^{(2)}$; and $C^{(3)}$, respectively. Based on the octal numbers, an octal number $g_0$ of the component code generator polynomial corresponding to the component code output bit sequence $C^{(0)}$ is equal to 133 (i.e., $g_0 = 133$), an octal number $g_1$ of the component code generator polynomial corresponding to the component code output bit sequence $C^{(1)}$ is equal to 171 (i.e., $g_1 = 171$), an octal number $g_2$ of the component code generator polynomial corresponding to the component code output bit sequence $C^{(2)}$ is equal to 165 (i.e., $g_2 = 165$), and an octal number $g_3$ of the component code generator polynomial corresponding to the component code output bit sequence $C^{(3)}$ is equal to 123 (i.e., $g_3 = 123$).

In some embodiments, the convolutional encoding manner may be tail-biting **convolutional** coding (TBCC). Therefore, initial values of the six shift registers in FIG. 3 may be equal to values of the last six bits of the information bit sequence, respectively, so as to ensure that the initial state and the final state of the convolutional encoding are the same.

For example, the shift registers include $S_0, S_1, S_2, S_3, S_4$, and $S_5$, and their initial values are set to $S_i = b_{(K-1-i)}$, and i is equal to 0, 1, ..., 5. The output corresponding to the i-th component code is $C^{(i)}$, and i is equal to 0, 1, ..., T-1, that is, the output bit sequence corresponding to the input k-th bit is expressed as $C_k^{(0)}, C_k^{(1)}, ..., C_k^{(T-1)}$, where k = 0, 1, ..., K - 1. For example, in a case where the coding rate used for the convolutional encoding is 1/2, a total of two component code output bit sequences may be obtained by performing encoding through the component code generator polynomials $g_0(D)$ and $g_1(D)$. In this case, T is equal to 2. In a case where the coding rate used for the convolutional encoding is 1/4, a total of four component code output bit sequences may be obtained by performing encoding through the component code generator polynomials $g_0(D), g_1(D), g_2(D)$, and $g_3(D)$. In this case, T is equal to 4.

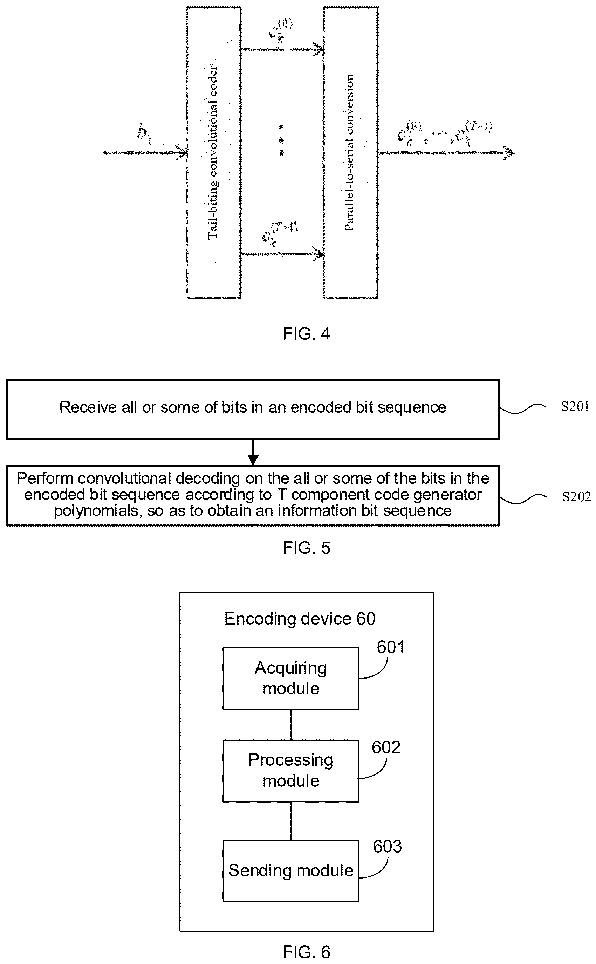

Furthermore, as shown in FIG. 4, parallel-to-serial conversion may also be performed on the obtained component code output bit sequences, so as to obtain an output bit sequence $C_k^{(0)}, C_k^{(1)}, ..., C_k^{(T-1)}$, with a length of T bits, corresponding to the k-th bit in the information bit sequence. For example, the encoded bit sequence obtained by performing the convolutional encoding on the entire information bit sequence may be expressed as: $d_j, j = 0, 1, ..., T \times K - 1$. In an example, the encoded bit sequence may be achieved according to the following pseudo code:

$$j = 0;$$

$$\text{for } k = 0 \text{ to } K - 1$$

$$\text{for } i = 0 \text{ to } T - 1$$

$$d_j = C_k^{(i)};$$

$$j = j + 1;$$

$$\text{end for}$$

$$\text{end for.}$$

In an implementation 2, a value of the constraint length of the convolutional encoding is 7. In this case, the number of required shift registers may be a difference between 7 and 1 (i.e., 7 - 1 = 6), and the highest degree of the set of preset component code generator polynomials is 6. The set of preset component code generator polynomials includes at least one of the following component code generator polynomials:

$$g_0(D) = 1 + D^1 + D^3 + D^4 + D^6;$$

$$g_1(D) = 1 + D^3 + D^4 + D^5 + D^6;$$

$$g_2(D) = 1 + D^2 + D^4 + D^5 + D^6;$$

$$g_3(D) = 1 + D^1 + D^2 + D^3 + D^6;$$

$$g_4(D) = 1 + D^2 + D^3 + D^4 + D^6;$$

$$g_5(D) = 1 + D^1 + D^2 + D^3 + D^5 + D^6;$$

$$g_6(D) = 1 + D^2 + D^3 + D^4 + D^6;$$

$$g_7(D) = 1 + D^1 + D^4 + D^6;$$

$$g_8(D) = 1 + D^1 + D^3 + D^4 + D^5 + D^6;$$

$$g_9(D) = 1 + D^2 + D^3 + D^4 + D^6;$$

$$g_{10}(D) = 1 + D^3 + D^4 + D^5 + D^6;$$

or

$$g_{11}(D) = 1 + D^2 + D^3 + D^4 + D^6.$$

Octal numbers corresponding to the component code generator polynomials mentioned above are 155, 117, 127, 171, 135, 173, 135, 145, 157, 135, 117, and 135, respectively. In a case where component code generator vectors are represented in binary, the component code generator vectors are: {1, 1, 0, 1, 1, 0, 1}, {1, 0, 0, 1, 1, 1, 1}, {1, 0, 1, 0, 1, 1, 1}, {1, 1, 1, 1, 0, 0, 1}, {1, 0, 1, 1, 1, 0, 1}, {1, 1, 1, 1, 0, 1, 1}, {1, 0, 1, 1, 1, 0, 1}, {1, 1, 0, 0, 1, 0, 1}, {1, 1, 0, 1, 1, 1, 1}, {1, 0, 1, 1, 1, 0, 1}, {1, 0, 0, 1, 1, 1, 1}, and {1, 0, 1, 1, 1, 0, 1}, respectively.

Furthermore, the transmitting end may determine the T component code generator polynomials for the convolutional encoding from the set of component code generator polynomials mentioned above. T may be equal to 2, 3, 4, 5, 6, 8, 10, or 12.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^1 + D^3 + D^4 + D^6$ and $g_1(D) = 1 + D^3 + D^4 + D^5 + D^6$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^1 + D^3 + D^4 + D^6$, $g_1(D) = 1 + D^3 + D^4 + D^5 + D^6$, and $g_2(D) = 1 + D^2 + D^4 + D^5 + D^6$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^1 + D^3 + D^4 + D^6$, $g_1(D) = 1 + D^3 + D^4 + D^5 + D^6$, $g_2(D) = 1 + D^2 + D^4 + D^5 + D^6$, and $g_3(D) = 1 + D^1 + D^2 + D^3 + D^6$ are used to for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^1 + D^3 + D^4 + D^6$, $g_1(D) = 1 + D^3 + D^4 + D^5 + D^6$, $g_2(D) = 1 + D^2 + D^4 + D^5 + D^6$, $g_3(D) = 1 + D^1 + D^2 + D^3 + D^6$, $g_4(D) = 1 + D^2 + D^3 + D^4 + D^6$, and $g_5(D) = 1 + D^1 + D^2 + D^3 + D^5 + D^6$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^1 + D^3 + D^4 + D^6$, $g_1(D) = 1 + D^3 + D^4 + D^5 + D^6$, $g_2(D) = 1 + D^2 + D^4 + D^5 + D^6$, $g_3(D) = 1 + D^1 + D^2 + D^3 + D^6$, $g_4(D) = 1 + D^2 + D^3 + D^4 + D^6$, $g_5(D) = 1 + D^1 + D^2 + D^3 + D^5 + D^6$, $g_6(D) = 1 + D^2 + D^3 + D^4 + D^6$, and $g_7(D) = 1 + D^1 + D^4 + D^6$ are used for the convolutional encoding to obtain the encoded bit sequence.

In some embodiments, the T component code generator polynomials used for the convolutional encoding further include at least one of the following: $1 + D^1 + D^3 + D^4 + D^6$, $1 + D^2 + D^4 + D^5 + D^6$, and $1 + D^1 + D^4 + D^6$. The octal numbers corresponding to the component code generator polynomials are 155, 127, and 145, respectively. In a case where component code generator vectors are represented in binary, the component code generator vectors are {1, 1, 0, 1, 1, 0, 1}, {1, 0, 1, 0, 1, 1, 1}, and {1, 1, 0, 0, 1, 0, 1}, respectively.

In addition, the information bit sequence is $b_0, b_1, b_2, b_3, ..., b_{K-1}$, K is the length of the information bit sequence, and then the convolutional encoding is performed according to the component code generator polynomials determined in the examples mentioned above. For the specific process, reference may be referred to the specific description of the convolutional encoding process in the implementation 1, and details will not be repeated herein.

In an implementation 3, a value of the constraint length of the convolutional encoding is 7. In this case, the number of required shift registers may be a difference between 7 and 1 (i.e., 7 - 1 = 6), and the highest degree of the set of preset component code generator polynomials is 6. The set of preset component code generator polynomials includes at least one of the following component code generator polynomials:

$$g_0(D) = 1 + D^1 + D^2 + D^3 + D^4 + D^6;$$

$$g_1(D) = 1 + D^2 + D^3 + D^5 + D^6;$$

$$g_2(D) = 1 + D^1 + D^4 + D^6;$$

$$g_3(D) = 1 + D^3 + D^4 + D^5 + D^6;$$

$$g_4(D) = 1 + D^2 + D^4 + D^5 + D^6;$$

$$g_5(D) = 1 + D^1 + D^3 + D^4 + D^5 + D^6;$$

$$g_6(D) = 1 + D^1 + D^2 + D^4 + D^6;$$

$$g_7(D) = 1 + D^1 + D^3 + D^6;$$

$$g_8(D) = 1 + D^2 + D^3 + D^4 + D^5 + D^6;$$

$$g_9(D) = 1 + D^1 + D^3 + D^4 + D^6;$$

$$g_{10}(D) = 1 + D^3 + D^4 + D^5 + D^6;$$

or

$$g_{11}(D) = 1 + D^2 + D^4 + D^5 + D^6.$$

Octal numbers corresponding to the component code generator polynomials mentioned above are 175, 133, 145, 117, 127, 157, 165, 151, 137, 155, 117 and 127, respectively. In a case where component code generator vectors are represented in binary, the component code generator vectors are: {1, 1, 1, 1, 1, 0, 1}, {1, 0, 1, 1, 0, 1, 1}, {1, 1, 0, 0, 1, 0, 1}, {1, 0, 0, 1, 1, 1, 1}, {1, 0, 1, 0, 1, 1, 1}, {1, 1, 0, 1, 1, 1, 1}, {1, 1, 1, 0, 1, 0, 1}, {1, 1, 0, 1, 0, 0, 1}, {1, 0, 1, 1, 1, 1, 1}, {1, 1, 0, 1, 1, 0, 1}, {1, 0, 0, 1, 1, 1, 1}, and {1, 0, 1, 0, 1, 1, 1}, respectively.

Furthermore, the transmitting end may determine the T component code generator polynomials for the convolutional encoding from the set of component code generator polynomials mentioned above. T may be equal to 2, 3, 4, 5, 6, 8, 10, or 12.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

For example, the transmitting end may use 2, 3, 4, 5, 6, 8, 10 or 12 component code generator polynomials of the 12 component code generator polynomials mentioned above to perform the convolutional encoding, so as to obtain the encoded bit sequence. For example, at least the generator polynomials $g_0(D) = 1 + D^1 + D^2 + D^3 + D^4 + D^6$ and $g_1(D) = 1 + D^2 + D^3 + D^5 + D^6$ are used for the convolutional encoding to obtain the encoded bit sequence, which will not be listed one by one.

In some embodiments, the T component code generator polynomials used for the convolutional encoding further include at least one of the following: $1 + D^1 + D^2 + D^3 + D^4 + D^6$, $1 + D^1 + D^4 + D^6$, $1 + D^2 + D^4 + D^5 + D^6$, $1 + D^1 + D^3 + D^6$, $1 + D^2 + D^3 + D^4 + D^5 + D^6$, $1 + D^1 + D^3 + D^4 + D^6$, and $1 + D^2 + D^4 + D^5 + D^6$. The octal numbers corresponding to the component code generator polynomials are 175, 145, 127, 151, 137, 155 and 127, respectively. In a case where component code generator vectors are represented in binary, the component code generator vectors are {1, 1, 1, 1, 1, 0, 1}, {1, 1, 0, 0, 1, 0, 1}, {1, 0, 1, 0, 1, 1, 1}, {1, 1, 0, 1, 0, 0, 1}, {1, 0, 1, 1, 1, 1, 1}, {1, 1, 0, 1, 1, 0, 1}, and {1, 0, 1, 0, 1, 1, 1}, respectively.

In addition, the information bit sequence is $b_0$, $b_1$, $b_2$, $b_3$, ..., $b_{K-1}$, K is the length of the information bit sequence, and then the convolutional encoding is performed according to the component code generator polynomials determined in the examples mentioned above. For the specific process, reference may be referred to the specific description of the convolutional encoding process in the implementation 1, and details will not be repeated herein.

In an implementation 4, a value of the constraint length of the convolutional encoding is 7. In this case, the number of required shift registers may be a difference between 7 and 1 (i.e., 7 - 1 = 6), and the highest degree of the set of preset component code generator polynomials is 6. The set of preset component code generator polynomials includes at least one of the following component code generator polynomials:

$$g_0(D) = 1 + D^1 + D^3 + D^4 + D^6;$$

$$g_1(D) = 1 + D^2 + D^3 + D^4 + D^5 + D^6;$$

$$g_2(D) = 1 + D^2 + D^5 + D^6;$$

$$g_3(D) = 1 + D^1 + D^2 + D^3 + D^6;$$

$$g_4(D) = 1 + D^2 + D^4 + D^5 + D^6;$$

$$g_5(D) = 1 + D^1 + D^2 + D^3 + D^5 + D^6;$$

$$g_6(D) = 1 + D^1 + D^2 + D^4 + D^6;$$

$$g_7(D) = 1 + D^3 + D^5 + D^6;$$

$$g_8(D) = 1 + D^1 + D^2 + D^3 + D^4 + D^6;$$

$$g_9(D) = 1 + D^1 + D^3 + D^4 + D^6;$$

$$g_{10}(D) = 1 + D^3 + D^4 + D^5 + D^6;$$

or

$$g_{11}(D) = 1 + D^2 + D^4 + D^5 + D^6.$$

Octal numbers corresponding to the component code generator polynomials mentioned above are 155, 137, 123, 171, 127, 173, 165, 113, 175, 155, 117 and 127, respectively. In a case where component code generator vectors are represented in binary, the component code generator vectors are: {1, 1, 0, 1, 1, 0, 1}, {1, 0, 1, 1, 1, 1, 1}, {1, 0, 1, 0, 0, 1, 1}, {1, 1, 1, 1, 0, 0, 1}, {1, 0, 1, 0, 1, 1, 1}, {1, 1, 1, 1, 0, 1, 1}, {1, 1, 1, 0, 1, 0, 1}, {1, 0, 0, 1, 0, 1, 1}, {1, 1, 1, 1, 1, 0, 1}, {1, 1, 0, 1, 1, 0, 1}, {1, 0, 0, 1, 1, 1, 1}, and {1, 0, 1, 0, 1, 1, 1}, respectively.

Furthermore, the transmitting end may determine the T component code generator polynomials for the convolutional encoding from the set of component code generator polynomials mentioned above. T may be equal to 2, 3, 4, 5, 6, 8, 10, or 12. In an example, T is equal to 6, J is equal to 6, and the set of preset component code generator polynomials includes the following component code generator polynomials: $g_0$ (D) = 1 + D$^1$ + D$^3$ + D$^4$ + D$^6$; $g_1$(D) = 1 + D$^2$ + D$^3$ + D$^4$ + D$^5$ + D$^6$; $g_2$(D) = 1 + D$^2$ + D$^5$ + D$^6$; $g_3$(D) = 1 + D$^1$ + D$^2$ + D$^3$ + D$^6$; $g_4$(D)= 1 + D$^1$ +D$^2$ + D$^3$ + D$^6$; and $g_5$(D) = 1 + D$^1$ + D$^2$ + D$^3$ + D$^5$ + D$^6$.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

For example, the transmitting end may use 2, 3, 4, 5, 6, 8, 10 or 12 component code generator polynomials of the 12 component code generator polynomials mentioned above to perform the convolutional encoding, so as to obtain the encoded bit sequence. For example, at least the generator polynomials $g_0$(D) = 1 + D$^1$ + D$^3$ + D$^4$ + D$^6$ and $g_1$ (D) = 1 + D$^2$ + D$^3$ + D$^4$ + D$^5$ + D$^6$ are used for the convolutional encoding to obtain the encoded bit sequence, which will not be listed one by one.

In some embodiments, the T component code generator polynomials used for the convolutional encoding further include at least one of: 1 + D$^1$ + D$^3$ + D$^4$ + D$^6$, 1 +D$^2$ + D$^3$ + D$^4$ + D$^5$ + D$^6$, 1 + D$^2$ + D$^4$ + D$^5$ + D$^6$, 1 + D$^3$ + D$^5$ + D$^6$, and 1 + D$^1$ + D$^2$ + D$^3$ + D$^4$ + D$^6$. The octal numbers corresponding to the component code generator polynomials are 155, 137, 127, 113, and 175, respectively. In a case where component code generator vectors are represented in binary, the component code generator vectors are {{1, 1, 0, 1, 1, 0, 1}, {1, 0, 1, 1, 1, 1, 1}, {1, 0, 1, 0, 1, 1, 1}, {1, 0, 0, 1, 0, 1, 1}, and {1, 1, 1, 1, 1, 0, 1}, respectively.

In addition, the information bit sequence is $b_0$, $b_1$, $b_2$, $b_3$, ..., $b_{K-1}$, K is the length of the information bit sequence, and then the convolutional encoding is performed according to the component code generator polynomials determined in the examples mentioned above. For the specific process, reference may be referred to the specific description of the convolutional encoding process in the implementation 1, and details will not be repeated herein.

In an implementation 5, a value of the constraint length of the convolutional encoding is 7. In this case, the number of required shift registers may be a difference between 7 and 1 (i.e., 7 - 1 = 6), and the highest degree of the set of preset component code generator polynomials is 6. The set of preset component code generator polynomials includes at least one of the following component code generator polynomials:

$$g_0(D) = 1 + D^1 + D^2 + D^3 + D^6;$$

$$g_1(D) = 1 + D^1 + D^3 + D^4 + D^6;$$

$$g_2(D) = 1 + D^2 + D^4 + D^5 + D^6;$$

or

$$g_3(D) = 1 + D^3 + D^4 + D^5 + D^6.$$

Octal numbers corresponding to the component code generator polynomials mentioned above are 171, 155, 127 and 117, respectively. In a case where component code generator vectors are represented in binary, the component code generator vectors are: {1, 1, 1, 1, 0, 0, 1}, {1, 1, 0, 1, 1, 0, 1}, {1, 0, 1, 0, 1, 1, 1}, and {1, 0, 0, 1, 1, 1, 1}, respectively.

Furthermore, the transmitting end may determine the T component code generator polynomials for the convolutional encoding from the set of component code generator polynomials mentioned above. T may be equal to 2, 3 or 4. For example, if the coding rate of the convolutional encoding is 1/4, T may be equal to 4. That is to say, the set of preset component code generator polynomials includes: $g_0(D) = 1 + D^1 + D^2 + D^3 + D^6$; $g_1(D) = 1 + D^1 + D^3 + D^4 + D^6$; $g_2(D) = 1 + D^2 + D^4 + D^5 + D^6$; and $g_3(D) = 1 + D^3 + D^4 + D^5 + D^6$.

In addition, the information bit sequence is $b_0$, $b_1$, $b_2$, $b_3$, ..., $b_{K-1}$, K is the length of the information bit sequence, and then the convolutional encoding is performed according to the component code generator polynomials determined in the examples mentioned above. For the specific process, reference may be referred to the specific description of the convolutional encoding process in the implementation 1, and details will not be repeated herein.

In an implementation 6, a value of the constraint length of the convolutional encoding is 9. In this case, the number of required shift registers may be a difference between 9 and 1 (i.e., 9 - 1 = 8), and the highest degree of the set of preset component code generator polynomials is 8. The set of preset component code generator polynomials includes at least one of the following component code generator polynomials:

$$g_0(D) = 1 + D^2 + D^3 + D^4 + D^8;$$

$$g_1(D) = 1 + D^1 + D^2 + D^3 + D^5 + D^7 + D^8;$$

$$g_2(D) = 1 + D^1 + D^2 + D^5 + D^6 + D^8;$$

$$g_3(D) = 1 + D^2 + D^4 + D^7 + D^8;$$

$$g_4(D) = 1 + D^1 + D^2 + D^4 + D^5 + D^6 + D^7 + D^8;$$

$$g_5(D) = 1 + D^3 + D^5 + D^6 + D^8;$$

$$g_6(D) = 1 + D^1 + D^2 + D^3 + D^5 + D^7 + D^8;$$

$$g_7(D) = 1 + D^1 + D^2 + D^3 + D^6 + D^8;$$

$$g_8(D) = 1 + D^1 + D^3 + D^5 + D^6 + D^7 + D^8;$$

$$g_9(D) = 1 + D^1 + D^3 + D^4 + D^5 + D^8;$$

$$g_{10}(D) = 1 + D^1 + D^2 + D^3 + D^6 + D^8;$$

or

$$g_{11}(D) = 1 + D^1 + D^3 + D^5 + D^6 + D^7 + D^8.$$

Octal numbers corresponding to the component code generator polynomials mentioned above are 561, 753, 715, 523, 737, 455, 753, 745, 657, 671, 745 and 657, respectively. In a case where component code generator vectors are represented in binary, the component code generator vectors are: {1, 0, 1, 1, 1, 0, 0, 0, 1}, {1, 1, 1, 1, 0, 1, 0, 1, 1}, {1, 1, 1, 0, 0, 1, 1, 0, 1}, {1, 0, 1, 0, 1, 0, 0, 1, 1}, {1, 1, 1, 1, 0, 1, 1, 1, 1},{1, 0, 0, 1, 0, 1, 1, 0, 1}, {1, 1, 1, 1, 0, 1, 0, 1, 1}, {1, 1, 1, 1, 0, 0, 1, 0, 1}, {1, 1, 0, 1, 0, 1, 1, 1, 1}, {1, 1, 0, 1, 1, 1, 0, 0, 1}, {1, 1, 1, 1, 0, 0, 1, 0, 1}, and {1, 1, 0, 1, 0, 1, 1, 1, 1}, respectively.

Furthermore, the transmitting end may determine the T component code generator polynomials for the convolutional encoding from the set of component code generator polynomials mentioned above.

In some embodiments, the T component code generator polynomials used for the convolutional encoding include at least the first J component code generator polynomials in the 12 generator polynomials mentioned above. A value of J may be 4, 5, 6, 7, 8, 9 or 10, and J is an integer less than or equal to T.

In an example, the convolutional encoding uses at least four of the 12 generator polynomials mentioned above for encoding, so as to obtain the encoded bit sequence. For example, at least the generator polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$, and $g_3(D) = 1 + D^2 + D^4 + D^7 + D^8$ are used for the convolutional encoding to obtain the encoded bit sequence.

In another example, the convolutional encoding uses at least six of the 12 generator polynomials mentioned above for encoding, so as to obtain the encoded bit sequence. For example, at least the generator polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$, $g_3(D) = 1 + D^2 + D^4 + D^7 + D^8$, $g_4(D) = 1 + D^1 + D^2 + D^4 + D^5 + D^6 + D^7 + D^8$, and $g_5(D) = 1 + D^3 + D^5 + D^6 + D^8$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$, $g_3(D) = 1 + D^2 + D^4 + D^7 + D^8$, $g_4(D) = 1 + D^1 + D^2 + D^4 + D^5 + D^6 + D^7 + D^8$, $g_5(D) = 1 + D^3 + D^5 + D^6 + D^8$, $g_6(D) = 1 + D^1 + D^2 + D^3 + D^5 + D^7 + D^8$, and $g_7(D) = 1 + D^1 + D^2 + D^3 + D^6 + D^8$ are used for the convolutional encoding to obtain the encoded bit sequence.

In some embodiments, the T component code generator polynomials used for the convolutional encoding further include at least one of: $1 + D^1 + D^2 + D^5 + D^6 + D^8$, $1 + D^2 + D^4 + D^7 + D^8$, $1 + D^1 + D^2 + D^4 + D^5 + D^6 + D^7 + D^8$, $1 + D^3 + D^5 + D^6 + D^8$, $1 + D^1 + D^2 + D^3 + D^5 + D^7 + D^8$, $1 + D^1 + D^2 + D^3 + D^6 + D^8$, $1 + D^1 + D^3 + D^5 + D^6 + D^7 + D^8$, $1 + D^1 + D^3 + D^4 + D^5 + D^8$, $1 + D^1 + D^2 + D^3 + D^6 + D^8$, and $1 + D^1 + D^3 + D^5 + D^6 + D^7 + D^8$. The octal numbers corresponding to the component code generator polynomials are 715, 523, 737, 455, 753, 745, 657, 671, 745 and 657, respectively. In a case where component code generator vectors are represented in binary, the component code generator vectors are {1, 1, 1, 0, 0, 1, 1, 0, 1}, {1, 0, 1, 0, 1, 0, 0, 1, 1}, {1, 1, 1, 0, 1, 1, 1, 1, 1}, {1, 0, 0, 1, 0, 1, 1, 0, 1}, {1, 1, 1, 1, 0, 1, 0, 1, 1}, {1, 1, 1, 1, 0, 0, 1, 0, 1}, {1, 1, 0, 1, 0, 1, 1, 1, 1}, {1, 1, 0, 1, 1, 1, 0, 0, 1}, {1, 1, 1, 1, 0, 0, 1, 0, 1}, and {1, 1, 0, 1, 0, 1, 1, 1, 1}, respectively. A value of T may be 2, 3, 4, 5, 6, 7, 8, 10 or 12. In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In addition, the information bit sequence is $b_0$, $b_1$, $b_2$, $b_3$, ..., $b_{K-1}$, K is the length of the information bit sequence, and then the convolutional encoding is performed according to the component code generator polynomials determined in the examples mentioned above. For the specific process, reference may be referred to the specific description of the convolutional encoding process in the implementation 1, and details will not be repeated herein.

In an implementation 7, a value of the constraint length of the convolutional encoding is 9. In this case, the number of required shift registers may be a difference between 9 and 1 (i.e., 9 - 1 = 8), and the highest degree of the set of preset component code generator polynomials is 8. The set of preset component code generator polynomials includes at least one of the following component code generator polynomials:

$$g_0(D) = 1 + D^2 + D^3 + D^5 + D^6 + D^7 + D^8;$$

$$g_1(D) = 1 + D^1 + D^3 + D^4 + D^7 + D^8;$$

$$g_2(D) = 1 + D^1 + D^2 + D^5 + D^8;$$

$$g_3(D) = 1 + D^1 + D^2 + D^3 + D^4 + D^6 + D^8;$$

$$g_4(D) = 1 + D^2 + D^4 + D^5 + D^6 + D^8;$$

$$g_5(D) = 1 + D^2 + D^5 + D^6 + D^7 + D^8;$$

$$g_6(D) = 1 + D^1 + D^3 + D^5 + D^6 + D^7 + D^8;$$

$$g_7(D) = 1 + D^3 + D^4 + D^5 + D^7 + D^8;$$

$$g_8(D) = 1 + D^1 + D^2 + D^3 + D^6 + D^8;$$

$$g_9(D) = 1 + D^1 + D^3 + D^5 + D^6 + D^7 + D^8;$$

$$g_{10}(D) = 1 + D^2 + D^3 + D^5 + D^8;$$

or

$$g_{11}(D) = 1 + D^1 + D^2 + D^3 + D^5 + D^7 + D^8.$$

Octal numbers corresponding to the component code generator polynomials mentioned above are 557, 663, 711, 765, 535, 517, 657, 473, 745, 657, 551, and 753, respectively. In a case where component code generator vectors are represented in binary, the component code generator vectors are: {1, 0, 1, 1, 0, 1, 1, 1, 1}, {1, 1, 0, 1, 1, 0, 0, 1, 1}, {1, 1, 1, 0, 0, 1, 0, 0, 1}, {1, 1, 1, 1, 1, 0, 1, 0, 1}, {1, 0, 1, 0, 1, 1, 1, 0, 1}, {1, 0, 1, 0, 0, 1, 1, 1, 1}, {1, 1, 0, 1, 0, 1, 1, 1, 1}, {1, 0, 0, 1, 1, 1, 0, 1, 1}, {1, 1, 1, 1, 0, 0, 1, 0, 1}, {1, 1, 0, 1, 0, 1, 1, 1, 1}, {1, 0, 1, 1, 0, 1, 0, 0, 1}, and {1, 1, 1, 1, 0, 1, 0, 1, 1}, respectively.

In some embodiments, the T component code generator polynomials used for the convolutional encoding include at least the first J component code generator polynomials in the 12 generator polynomials mentioned above. A value of J may be 4, 5, 6, 7, 8, 9 or 10, and J is an integer less than or equal to T. T may be equal to 2, 3, 4, 5, 6, 8, 10, or 12.

In an example, the convolutional encoding uses at least four of the 12 generator polynomials mentioned above for encoding, so as to obtain the encoded bit sequence. For example, at least the generator polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$, and $g_3(D) = 1 + D^1 + D^2 + D^3 + D^4 + D^6 + D^8$ are used for the convolutional encoding to obtain the encoded bit sequence.

In another example, the convolutional encoding uses at least five of the 12 generator polynomials mentioned above for encoding, so as to obtain the encoded bit sequence. For example, at least the generator polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$, $g_3(D) = 1 + D^1 + D^2 + D^3 + D^4 + D^6 + D^8$, and $g_4(D) = 1 + D^2 + D^4 + D^5 + D^6 + D^8$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$, $g_3(D) = 1 + D^1 + D^2 + D^3 + D^4 + D^6 + D^8$, $g_4(D) = 1 + D^2 + D^4 + D^5 + D^6 + D^8$, and $g_5(D) = 1 + D^2 + D^5 + D^6 + D^7 + D^8$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$, $g_3(D) = 1 + D^1 + D^Z + D^3 + D^4 + D^6 + D^8$, $g_4(D) = 1 + D^2 + D^4 + D^5 + D^6 + D^8$, $g_5(D) = 1 + D^2 + D^5 + D^6 + D^7 + D^8$, $g_6(D) = 1 + D^1 + D^3 + D^5 + D^6 + D^7 + D^8$, and $g_7(D) = 1 + D^3 + D^4 + D^5 + D^7 + D^8$ are used for the convolutional encoding to obtain the encoded bit sequence.

In some embodiments, the T component code generator polynomials used for the convolutional encoding further include at least one of: $1 + D^1 + D^2 + D^3 + D^4 + D^6 + D^8$, $1 + D^2 + D^4 + D^5 + D^6 + D^8$, $1 + D^2 + D^5 + D^6 + D^7 + D^8$, $1 + D^1 + D^3 + D^5 + D^6 + D^7 + D^8$, $1 + D^3 + D^4 + D^5 + D^7 + D^8$, $1 + D^1 + D^2 + D^3 + D^6 + D^8$, $1 + D^1 + D^3 + D^5 + D^6 + D^7 + D^8$, $1 + D^2 + D^3 + D^5 + D^8$, and $1 + D^1 + D^2 + D^3 + D^5 + D^7 + D^8$. The octal numbers corresponding to the component code generator polynomials are 765, 535, 517, 657, 473, 745, 657, 551 and 753, respectively. In a case where component code generator vectors are represented in binary, the component code generator vectors are {1, 1, 1, 1, 1, 0, 1, 0, 1}, {1, 0, 1, 0, 1, 1, 1, 0, 1}, {1, 0, 1, 0, 0, 1, 1, 1, 1}, {1, 1, 0, 1, 0, 1, 1, 1, 1}, {1, 0, 0, 1, 1, 1, 0, 1, 1}, {1, 1, 1, 1, 0, 0, 1, 0, 1}, {1, 1, 0, 1, 0, 1, 1, 1, 1}, {1, 0, 1, 1, 0, 1, 0, 0, 1}, and {1, 1, 1, 1, 0, 1, 0, 1, 1}, respectively. A value of T may be 2, 3, 4, 5, 6, 7, 8, 10 or 12. In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In addition, the information bit sequence is $b_0$, $b_1$, $b_2$, $b_3$, ..., $b_{K-1}$, K is the length of the information bit sequence, and then the convolutional encoding is performed according to the component code generator polynomials determined in the examples mentioned above. For the specific process, reference may be referred to the specific description of the convolutional encoding process in the implementation 1, and details will not be repeated herein.

In an implementation 8, a value of the constraint length of the convolutional encoding is 9. In this case, the number of required shift registers may be a difference between 9 and 1 (i.e., 9 - 1 = 8), and the highest degree of the set of preset component code generator polynomials is 8. The set of preset component code generator polynomials includes at least one of the following component code generator polynomials:

$$g_0(D) = 1 + D^3 + D^4 + D^6 + D^8;$$

$$g_1(D) = 1 + D^1 + D^2 + D^3 + D^4 + D^5 + D^8;$$

$$g_2(D) = 1 + D^1 + D^3 + D^4 + D^5 + D^7 + D^8;$$

$$g_3(D) = 1 + D^2 + D^3 + D^6 + D^7 + D^8;$$

$$g_4(D) = 1 + D^2 + D^4 + D^5 + D^6 + D^8;$$

$$g_5(D) = 1 + D^2 + D^5 + D^6 + D^7 + D^8;$$

$$g_6(D) = 1 + D^1 + D^3 + D^5 + D^6 + D^7 + D^8;$$

$$g_7(D) = 1 + D^3 + D^4 + D^5 + D^7 + D^8;$$

$$g_8(D) = 1 + D^2 + D^5 + D^6 + D^7 + D^8;$$

$$g_9(D) = 1 + D^1 + D^2 + D^3 + D^5 + D^7 + D^8;$$

$$g_{10}(D) = 1 + D^3 + D^5 + D^6 + D^8;$$

or

$$g_{11}(D) = 1 + D^1 + D^2 + D^3 + D^5 + D^7 + D^8.$$

Octal numbers corresponding to the component code generator polynomials mentioned above are 465, 771, 673, 547, 535, 517, 657, 473, 517, 753, 455 and 753, respectively. In a case where component code generator vectors are represented in binary, the component code generator vectors are: {1, 0, 0, 1, 1, 0, 1, 0, 1}, {1, 1, 1, 1, 1, 1, 0, 0, 1}, {1, 1, 0, 1, 1, 1, 0, 1, 1}, {1, 0, 1, 1, 0, 0, 1, 1, 1}, {1, 0, 1, 0, 1, 1, 1, 0, 1}, {1, 0, 1, 0, 0, 1, 1, 1, 1}, {1, 1, 0, 1, 0, 1, 1, 1, 1}, {1, 0, 0, 1, 1, 1, 0, 1, 1}, {1, 0, 1, 0, 0, 1, 1, 1, 1}, {1, 1, 1, 1, 0, 1, 0, 1, 1}, {1, 0, 0, 1, 0, 1, 1, 0, 1}, and {1, 1, 1, 1, 0, 1, 0, 1, 1}, respectively.

Furthermore, the transmitting end may determine T component code generator polynomials for the convolutional encoding from the set of component code generator polynomials mentioned above. A value of T may be 2, 3, 4, 5, 6, 7, 8, 10 or 12.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^3 + D^4 + D^6 + D^8$ and $g_1(D) = 1 + D^1 + D^2 + D^3 + D^4 + D^5 + D^8$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^3 + D^4 + D^6 + D^8$, $g_1(D) = 1 + D^1 + D^2 + D^3 + D^4 + D^5 + D^8$, and $g_2(D) = 1 + D^1 + D^3 + D^4 + D^5 + D^7 +$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^3 + D^4 + D^6 + D^8$, $g_1(D) = 1 + D^1 + D^2 + D^3 + D^4 + D^5 + D^8$, $g_2(D) = 1 + D^1 + D^3 + D^4 + D^5 + D^7 + D^8$, and $g_3(D) = 1 + D^2 + D^3 + D^6 + D^7 + D^8$ are used for the convolutional encoding to obtain the encoded bit sequence.

In yet another example, the convolutional encoding uses at least five of the 12 generator polynomials mentioned above for encoding, so as to obtain the encoded bit sequence. For example, at least the generator polynomials $g_0(D) = 1 + D^3 + D^4 + D^6 + D^8$, $g_1(D) = 1 + D^1 + D^2 + D^3 + D^4 + D^5 + D^8$, $g_2(D) = 1 + D^1 + D^3 + D^4 + D^5 + D^7 + D^8$, $g_3(D) = 1 + D^2 + D^3 + D^6 + D^7 + D^8$, and $g_4(D) = 1 + D^2 + D^4 + D^5 + D^6 + D^8$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^3 + D^4 + D^6 + D^8$, $g_1(D) = 1 + D^1 + D^2 + D^3 + D^4 + D^5 + D^8$, $g_2(D) = 1 + D^1 + D^3 + D^4 + D^5 + D^7 + D^8$, $g_3(D) = 1 + D^2 + D^3 + D^6 + D^7 + D^8$, $g_4(D) = 1 + D^2 + D^4 + D^5 + D^6 + D^8$, and $g_5(D) = 1 + D^2 + D^5 + D^6 + D^7 + D^8$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^3 + D^4 + D^6 + D^8$, $g_1(D) = 1 + D^1 + D^2 + D^3 + D^4 + D^5 + D^8$, $g_2(D) = 1 + D^1 + D^3 + D^4 + D^5 + D^7 + D^8$, $g_3(D) = 1 + D^2 + D^3 + D^6 + D^7 + D^8$, $g_4(D) = 1 + D^2 + D^4 + D^5 + D^6 + D^8$, $g_5(D) = 1 + D^2 + D^5 + D^6 + D^7 + D^8$, $g_6(D) = 1 + D^1 + D^3 + D^5 + D^6 + D^7 + D^8$, and $g_7(D) = 1 + D^3 + D^4 + D^5 + D^7 + D^8$ are used for the convolutional encoding to obtain the encoded bit sequence.

In some embodiments, the set of preset component code generator polynomials may further include at least one of the following component code generator polynomials:

$$g_0(D) = 1 + D^2 + D^4 + D^5 + D^8;$$

$$g_1(D) = 1 + D^3 + D^4 + D^5 + D^6 + D^7 + D^8;$$

$$g_2(D) = 1 + D^1 + D^3 + D^4 + D^5 + D^7 + D^8;$$

$$g_3(D) = 1 + D^1 + D^2 + D^5 + D^6 + D^8;$$

$$g_4(D) = 1 + D^2 + D^3 + D^4 + D^6 + D^8;$$

$$g_5(D) = 1 + D^1 + D^2 + D^3 + D^6 + D^8;$$

$$g_6(D) = 1 + D^1 + D^2 + D^3 + D^5 + D^7 + D^8;$$

$$g_7(D) = 1 + D^1 + D^3 + D^4 + D^5 + D^8;$$

$$g_8(D) = 1 + D^1 + D^2 + D^3 + D^6 + D^8;$$

$$g_9(D) = 1 + D^1 + D^3 + D^5 + D^6 + D^7 + D^8;$$

$$g_{10}(D) = 1 + D^2 + D^3 + D^5 + D^8;$$

or

$$g_{11}(D) = 1 + D^1 + D^3 + D^5 + D^6 + D^7 + D^8.$$

Octal numbers corresponding to the component code generator polynomials are 531, 477, 673, 715, 565, 745, 753, 671, 745, 657, 551 and 657, respectively. In a case where component code generator vectors are represented in binary, the component code generator vectors are {1, 0, 1, 0, 1, 1, 0, 0, 1}, {1, 0, 0, 1, 1, 1, 1, 1, 1}, {1, 1, 0, 1, 1, 1, 1, 0, 1, 1}, {1, 1, 1, 0, 0, 1, 1, 0, 1}, {1, 0, 1, 1, 1, 0, 1, 0, 1}, {1, 1, 1, 1, 0, 0, 1, 0, 1}, {1, 1, 1, 1, 0, 1, 0, 1, 1}, {1, 1, 0, 1, 1, 1, 0, 0, 1}, {1, 1, 1, 1, 0, 0, 1, 0, 1}, {1, 1, 0, 1, 0, 1, 1, 1, 1}, {1, 0, 1, 1, 0, 1, 0, 0, 1}, and {1, 1, 0, 1, 0, 1, 1, 1, 1}, respectively. Furthermore, the transmitting end may determine the T component code generator polynomials for the convolutional encoding from the set of component code generator polynomials mentioned above. A value of T may be 2, 3, 4, 5, 6, 7, 8, 10 or 12. In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In addition, the information bit sequence is $b_0$, $b_1$, $b_2$, $b_3$, ..., $b_{K-1}$, K is the length of the information bit sequence, and then the convolutional encoding is performed according to the component code generator polynomials determined in the examples mentioned above. For the specific process, reference may be referred to the specific description of the convolutional encoding process in the implementation 1, and details will not be repeated herein.

In an implementation 9, a value of the constraint length of the convolutional encoding is 9. In this case, the number of required shift registers may be a difference between 9 and 1 (i.e., 9 - 1 = 8), and the highest degree of the set of preset component code generator polynomials is 8. The set of preset component code generator polynomials includes at least one of the following component code generator polynomials:

$$g_0(D) = 1 + D^2 + D^3 + D^4 + D^8;$$

$$g_1(D) = 1 + D^1 + D^2 + D^3 + D^5 + D^7 + D^8;$$

$$g_2(D) = 1 + D^1 + D^2 + D^5 + D^6 + D^8;$$

or

$$g_3(D) = 1 + D^2 + D^4 + D^7 + D^8.$$

In some embodiments, if the zero-th component code generator polynomial is $g_0(D) = 1 + D^2 + D^3 + D^4 + D^8$, the corresponding component code generator vector represented in binary is {1, 0, 1, 1, 1, 0, 0, 0, 1}, and the corresponding octal number is 561. If the first component code generator polynomial is $g_1(D) = 1 + D^1 + D^2 + D^3 + D^5 + D^7 + D^8$, the corresponding component code generator vector represented in binary is {1, 1, 1, 1, 0, 1, 0, 1, 1}, and the corresponding octal number is 753. If the second component code generator polynomial is $g_2(D) = 1 + D^1 + D^2 + D^5 + D^6 + D^8$, the corresponding component code generator vector represented in binary is {1, 1, 1, 0, 0, 1, 1, 0, 1}, and the corresponding octal number is 715. The third component code generator polynomial is at least one of: 1 + D2 + D5 + D6 + D7 + D8, 1 + D2 + D4 + D5 + D6 + D7 + D8, 1 + D3 + D4 + D5 + D6 + D8, 1 + D2 + D4 + D5 + D6 + D8, 1 + D2 + D3 + D6 + D7 + D8, 1 + D2 + D4 + D7 + D8, or 1 + D1 + D4 + D6 + D8, that is, the component code generator vector corresponding to the third component code is at least one of: {1, 0, 1, 0, 0, 1, 1, 1, 1}, {1, 0, 1, 0, 1, 1, 1, 1, 1}, {1, 0, 0, 1, 1, 1, 1, 0, 1}, {1, 0, 1, 0, 1, 1, 1, 0, 1}, {1, 0, 1, 1, 0, 0, 1, 1, 1}, {1, 0, 1, 0, 1, 0, 0, 1, 1}, or {1, 1, 0, 0, 1, 0, 1, 0, 1}. Correspondingly, the component code generator polynomial corresponding to the third component code corresponds to at least one of the following octal numbers: 517, 537, 475, 535, 547, 523, and 625.

Furthermore, the transmitting end may determine the T component code generator polynomials for the convolutional encoding from the set of component code generator polynomials mentioned above. For example, if the convolutional coding rate is 1/2, the value of T may be 2; if the convolutional coding rate is 1/4, the value of T may be 4.

In an example, the convolutional encoding uses at least the generator polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$, and $g_3(D) = 1 + D^2 + D^4 + D^7 + D^8$ for the convolutional encoding to obtain the encoded bit sequence. The octal numbers corresponding to the component code generator polynomials are 561, 753, 715, and 523, respectively.

In another example, the convolutional encoding uses at least the generator polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$, and $g_3(D) = 1 + D^1 + D^4 + D^6 + D^8$ for the convolutional encoding to obtain the encoded bit sequence. The octal numbers corresponding to the component code generator polynomials are 561, 753, 715, and 625, respectively.

In yet another example, the convolutional encoding uses at least the generator polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$, and $g_3(D) = 1 + D^2 + D^4 + D^5 + D^6 + D^7 + D^8$ for the convolutional encoding to obtain the encoded bit sequence. The octal numbers corresponding to the component code generator polynomials are 561, 753, 715, and 537, respectively.

In yet another example, the convolutional encoding uses at least the generator polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^4 + D^5 + D^6 + D^7 + D^8$, and $g_3(D) = 1 + D^1 + D^3 + D^6 + D^8$ for the convolutional encoding to obtain the encoded bit sequence. The octal numbers corresponding to the component code generator polynomials are 561, 753, 637, and 645, respectively.

In an implementation 10, a value of the constraint length of the convolutional encoding is 9. In this case, the number of required shift registers may be a difference between 9 and 1 (i.e., 9 - 1 = 8), and the highest degree of the set of preset component code generator polynomials is 8. If the zero-th component code generator polynomial in the preset component code generator polynomials is $g_0(D) = 1 + D^2 + D^3 + D^5 + D^6 + D^7 + D^8$, the corresponding component code generator vector represented in binary is {1, 0, 1, 1, 0, 1, 1, 1, 1}, and the corresponding octal number is 557. If the first component code generator polynomial is $g_1(D) = 1 + D^1 + D^3 + D^4 + D^7 + D^8$, the corresponding component code generator vector represented in binary is {1, 1, 0, 1, 1, 0, 0, 1, 1}, and corresponding octal number is 663. If the second component code generator polynomial is $g_2(D) = 1 + D^1 + D^2 + D^5 + D^8$, the corresponding component code generator vector represented in binary is {1, 1, 1, 0, 0, 1, 0, 0, 1}, and the corresponding octal number is 711. The third component code generator polynomial is at least one of: 1 + D1 + D2 + D3 + D4 + D6 + D8, 1 + D1 + D2 + D4 + D6 + D8, 1 + D2 + D4 + D5 + D6 + D8, 1 + D3 + D4 + D5 + D6 + D8, 1 + D2 + D3 + D4 + D5 + D6 + D8, or 1 + D4 + D5 + D6 + D8. Correspondingly, the component code generator vector corresponding to the third component code is at least one of: {1, 1, 1, 1, 1, 0, 1, 0, 1}, {1, 1, 1, 0, 1, 0, 1, 0, 1}, {1, 0, 1, 0, 1, 1, 1, 0, 1}, {1, 0, 0, 1, 1, 1, 1, 0, 1}, {1, 0, 1, 1, 1, 1, 1, 0, 1}, and {1, 0, 0, 0, 1, 1, 1, 0, 1}. Moreover, the component code generator polynomial corresponding to the third component code corresponds to at least one of the following octal numbers: 765, 725, 535, 475, 575 and 435.

Furthermore, the transmitting end may determine the T component code generator polynomials for the convolutional encoding from the set of component code generator polynomials mentioned above. For example, if the convolutional coding rate is 1/2, the value of T may be 2; if the convolutional coding rate is 1/4, the value of T may be 4.

In an example, the convolutional encoding uses at least the generator polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$, and $g_3(D) = 1 + D^1 + D^2 + D^3 + D^4 + D^6 + D^8$ for the convolutional encoding to obtain the encoded bit sequence. The octal numbers corresponding to the component code generator polynomials are 557, 663, 711, and 765, respectively.

In an implementation 11, a value of the constraint length of the convolutional encoding is 5. In this case, the number of required shift registers may be a difference between 5 and 1 (i.e., 5 - 1 = 4), and the highest degree of the set of preset component code generator polynomials is 4. The set of preset component code generator polynomials includes at least one of the following component code generator polynomials:

$$g_0(D) = 1 + D^3 + D^4;$$

$$g_1(D) = 1 + D^1 + D^2 + D^4;$$

$$g_2(D) = 1 + D^2 + D^3 + D^4;$$

$$g_3(D) = 1 + D^1 + D^3 + D^4;$$

$$g_4(D) = 1 + D^1 + D^2 + D^4;$$

$$g_5(D) = 1 + D^2 + D^3 + D^4;$$

$$g_6(D) = 1 + D^1 + D^2 + D^4;$$

$$g_7(D) = 1 + D^2 + D^3 + D^4;$$

$$g_8(D) = 1 + D^1 + D^2 + D^3 + D^4;$$

$$g_9(D) = 1 + D^2 + D^3 + D^4;$$

$$g_{10}(D) = 1 + D^1 + D^2 + D^4;$$

or

$$g_{11}(D) = 1 + D^2 + D^3 + D^4.$$

Octal numbers corresponding to the component code generator polynomials mentioned above are 23, 35, 27, 33, 35, 27, 35, 27, 37, 27, 35 and 27, respectively. In a case where component code generator vectors are represented in binary, the component code generator vectors are: {1, 0, 0, 1, 1}, {1, 1, 1, 0, 1}, {1, 0, 1, 1, 1}, {1, 1, 0, 1, 1}, {1, 1, 1, 0, 1}, {1, 0, 1, 1, 1}, {1, 1, 1, 0, 1}, {1, 0, 1, 1, 1}, {1, 1, 1, 1, 1}, {1, 0, 1, 1, 1}, {1, 1, 1, 0, 1}, and {1, 0, 1, 1, 1}, respectively.

Furthermore, the transmitting end may determine the T component code generator polynomials for the convolutional encoding from the set of component code generator polynomials mentioned above.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^3 + D^4$ and $g_1(D) = 1 + D^1 + D^2 + D^4$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^3 + D^4$, $g_1(D) = 1 + D^1 + D^2 + D^4$, and $g_2(D) = 1 + D^2 + D^3 + D^4$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^3 + D^4$, $g_1(D) = 1 + D^1 + D^2 + D^4$, $g_2(D) = 1 + D^2 + D^3 + D^4$, and $g_3(D) = 1 + D^1 + D^3 + D^4$ are used for the convolutional encoding to obtain the encoded bit sequence.

In yet another example, the convolutional encoding uses at least five of the 12 generator polynomials mentioned above for encoding, so as to obtain the encoded bit sequence. For example, at least the generator polynomials $g_0(D) = 1 + D^3 + D^4$, $g_1(D) = 1 + D^1 + D^2 + D^4$, $g_2(D) = 1 + D^2 + D^3 + D^4$, $g_3(D) = 1 + D^1 + D^3 + D^4$, and $g_4(D) = 1 + D^1 + D^2 + D^4$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^3 + D^4$, $g_1(D) = 1 + D^1 + D^2 + D^4$, $g_2(D) = 1 + D^2 + D^3 + D^4$, $g_3(D) = 1 + D^1 + D^3 + D^4$, $g_4(D) = 1 + D^1 + D^2 + D^4$, and $g_5(D) = 1 + D^2 + D^3 + D^4$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^3 + D^4$, $g_1(D) = 1 + D^1 + D^2 + D^4$, $g_2(D) = 1 + D^2 + D^3 + D^4$, $g_3(D) = 1 + D^1 + D^3 + D^4$, $g_4(D) = 1 + D^1 + D^2 + D^4$, $g_5(D) = 1 + D^2 + D^3 + D^4$, $g_6(D) = 1 + D^1 + D^2 + D^4$, $g_7(D) = 1 + D^2 + D^3 + D^4$ are used for the convolutional encoding to obtain the encoded bit sequence.

In some embodiments, the set of preset component code generator polynomials may further include at least one of the following component code generator polynomials:

$$g_0(D) = 1 + D^1 + D^4;$$

$$g_1(D) = 1 + D^2 + D^3 + D^4;$$

$$g_2(D) = 1 + D^1 + D^2 + D^4;$$

$$g_3(D) = 1 + D^1 + D^3 + D^4;$$

$$g_4(D) = 1 + D^1 + D^2 + D^4;$$

$$g_5(D) = 1 + D^2 + D^3 + D^4;$$

$$g_6(D) = 1 + D^1 + D^2 + D^4;$$

$$g_7(D) = 1 + D^2 + D^3 + D^4;$$

$$g_8(D) = 1 + D^1 + D^2 + D^3 + D^4;$$

$$g_9(D) = 1 + D^2 + D^3 + D^4;$$

$$g_{10}(D) = 1 + D^1 + D^2 + D^4;$$

or

$$g_{11}(D) = 1 + D^2 + D^3 + D^4.$$

Octal numbers corresponding to the component code generator polynomials are 31, 27, 35, 33, 35, 27, 35, 27, 37, 27, 35 and 27, respectively. In a case where component code generator vectors are represented in binary, the component code generator vectors are {1, 1, 0, 0, 1}, {1, 0, 1, 1, 1}, {1, 1, 1, 0, 1}, {1, 1, 0, 1, 1}, {1, 1, 1, 0, 1}, {1, 0, 1, 1, 1}, {1, 1, 1, 0, 1}, {1, 0, 1, 1, 1}, {1, 1, 1, 1, 1}, {1, 0, 1, 1, 1}, {1, 1, 1, 0, 1}, and {1, 0, 1, 1, 1}, respectively. Furthermore, the transmitting end may determine the T component code generator polynomials for the convolutional encoding from the set of component code generator polynomials mentioned above. In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^1 + D^4$ and $g_1(D) = 1 + D^2 + D^3 + D^4$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^1 + D^4$, $g_1(D) = 1 + D^2 + D^3 + D^4$, and $g_2(D) = 1 + D^1 + D^2 + D^4$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^1 + D^4$, $g_1(D) = 1 + D^2 + D^3 + D^4$, $g_2(D) = 1 + D^1 + D^2 + D^4$, and $g_3(D) = 1 + D^1 + D^3 + D^4$ are used for the convolutional encoding to obtain the encoded bit sequence.

In yet another example, the convolutional encoding uses at least five of the 12 generator polynomials mentioned above for encoding, so as to obtain the encoded bit sequence. For example, at least the generator polynomials $g_0(D) = 1 + D^1 + D^4$, $g_1(D) = 1 + D^2 + D^3 + D^4$, $g_2(D) = 1 + D^1 + D^2 + D^4$, $g_3(D) = 1 + D^1 + D^3 + D^4$, and $g_4(D) = 1 + D^1 + D^2 + D^4$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^1 + D^4$, $g_1(D) = 1 + D^2 + D^3 + D^4$, $g_2(D) = 1 + D^1 + D^2 + D^4$, $g_3(D) = 1 + D^1 + D^3 + D^4$, $g_4(D) = 1 + D^1 + D^2 + D^4$, and $g_5(D) = 1 + D^2 + D^3 + D^4$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^1 + D^4$, $g_1(D) = 1 + D^2 + D^3 + D^4$, $g_2(D) = 1 + D^1 + D^2 + D^4$, $g_3(D) = 1 + D^1 + D^3 + D^4$, $g_4(D) = 1 + D^1 + D^2 + D^4$, $g_5(D) = 1 + D^2 + D^3 + D^4$, $g_6(D) = 1 + D^1 + D^2 + D^4$, and $g_7(D) = 1 + D^2 + D^3 + D^4$ are used for the convolutional encoding to obtain the encoded bit sequence.

In an implementation 12, a value of the constraint length of the convolutional encoding is 6. In this case, the number of required shift registers may be a difference between 6 and 1 (i.e., 6 - 1 = 5), and the highest degree of the set of preset component code generator polynomials is 5. The set of preset component code generator polynomials includes at least one of the following component code generator polynomials:

$$g_0(D) = 1 + D^2 + D^4 + D^5;$$

$$g_1(D) = 1 + D^1 + D^2 + D^3 + D^5;$$

$$g_2(D) = 1 + D^3 + D^4 + D^5;$$

$$g_3(D) = 1 + D^1 + D^3 + D^4 + D^5;$$

$$g_4(D) = 1 + D^2 + D^3 + D^4 + D^5;$$

$$g_5(D) = 1 + D^1 + D^3 + D^5;$$

$$g_6(D) = 1 + D^1 + D^2 + D^3 + D^5;$$

$$g_7(D) = 1 + D^1 + D^2 + D^5;$$

$$g_8(D) = 1 + D^2 + D^4 + D^5;$$

$$g_9(D) = 1 + D^2 + D^3 + D^4 + D^5;$$

$$g_{10}(D) = 1 + D^1 + D^2 + D^3 + D^5;$$

or

$$g_{11}(D) = 1 + D^1 + D^3 + D^4 + D^5.$$

Octal numbers corresponding to the component code generator polynomials mentioned above are 53, 75, 47, 67, 57, 65, 75, 71, 53, 57, 75 and 67, respectively. In a case where component code generator vectors are represented in binary, the component code generator vectors are: {1, 0, 1, 0, 1, 1}, {1, 1, 1, 1, 0, 1}, {1, 0, 0, 1, 1, 1}, {1, 1, 0, 1, 1, 1}, {1, 0, 1, 1, 1, 1}, {1, 1, 0, 1, 0, 1}, {1, 1, 1, 1, 0, 1}, {1, 1, 1, 0, 0, 1}, {1, 0, 1, 0, 1, 1}, {1, 0, 1, 1, 1, 1}, {1, 1, 1, 1, 0, 1}, and {1, 1, 0, 1, 1, 1}, respectively.

Furthermore, the transmitting end may determine the T component code generator polynomials for the convolutional encoding from the set of component code generator polynomials mentioned above. A value of T may be 2, 3, 4, 5, 6, 7, 8, 10, or 12.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^2 + D^4 + D^5$ and $g_1(D) = 1 + D^1 + D^2 + D^3 + D^5$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^2 + D^4 + D^5$, $g_1(D) = 1 + D^1 + D^2 + D^3 + D^5$, and $g_2(D) = 1 + D^3 + D^4 + D^5$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^2 + D^4 + D^5$, $g_1(D) = 1 + D^1 + D^2 + D^3 + D^5$, $g_2(D) = 1 + D^3 + D^4 + D^5$, and $g_3(D) = 1 + D^1 + D^3 + D^4 + D^5$ are used for the convolutional encoding to obtain the encoded bit sequence.

In yet another example, the convolutional encoding uses at least five of the 12 generator polynomials mentioned above for encoding, so as to obtain the encoded bit sequence. For example, at least the generator polynomials $g_0(D) = 1 + D^2 + D^4 + D^5$, $g_1(D) = 1 + D^1 + D^2 + D^3 + D^5$, $g_2(D) = 1 + D^3 + D^4 + D^5$, $g_3(D) = 1 + D^1 + D^3 + D^4 + D^5$, and $g_4(D) = 1 + D^2 + D^3 + D^4 + D^5$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^2 + D^4 + D^5$, $g_1(D) = 1 + D^1 + D^2 + D^3 + D^5$, $g_2(D) = 1 + D^3 + D^4 + D^5$, $g_3(D) = 1 + D^1 + D^3 + D^4 + D^5$, $g_4(D) = 1 + D^2 + D^3 + D^4 + D^5$, and $g_5(D) = 1 + D^1 + D^3 + D^5$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 +$

$D^2 + D^4 + D^5$, $g_1(D) = 1 + D^1 + D^2 + D^3 + D^5$, $g_2(D) = 1 + D^3 + D^4 + D^5$, $g_3(D) = 1 + D^1 + D^3 + D^4 + D^5$, $g_4(D) = 1 + D^2 + D^3 + D^4 + D^5$, $g_5(D) = 1 + D^1 + D^3 + D^5$, $g_6(D) = 1 + D^1 + D^2 + D^3 + D^5$, and $g_7(D) = 1 + D^1 + D^2 + D^5$ are used for the convolutional encoding to obtain the encoded bit sequence.

In addition, the information bit sequence is $b_0$, $b_1$, $b_2$, $b_3$, ..., $b_{K-1}$, K is the length of the information bit sequence, and then the convolutional encoding is performed according to the component code generator polynomials determined in the examples mentioned above. For the specific process, reference may be referred to the specific description of the convolutional encoding process in the implementation 1, and details will not be repeated herein.

In some embodiments, the set of preset component code generator polynomials may further include at least one of the following component code generator polynomials:

$$g_0(D) = 1 + D^1 + D^3 + D^5;$$

$$g_1(D) = 1 + D^2 + D^3 + D^4 + D^5;$$

$$g_2(D) = 1 + D^1 + D^2 + D^5;$$

$$g_3(D) = 1 + D^1 + D^2 + D^4 + D^5;$$

$$g_4(D) = 1 + D^1 + D^2 + D^3 + D^5;$$

$$g_5(D) = 1 + D^2 + D^4 + D^5;$$

$$g_6(D) = 1 + D^2 + D^3 + D^4 + D^5;$$

$$g_7(D) = 1 + D^3 + D^4 + D^5;$$

$$g_8(D) = 1 + D^1 + D^3 + D^5;$$

$$g_9(D) = 1 + D^2 + D^3 + D^4 + D^5;$$

$$g_{10}(D) = 1 + D^1 + D^2 + D^3 + D^5;$$

or

$$g_{11}(D) = 1 + D^1 + D^2 + D^4 + D^5.$$

Octal numbers corresponding to the component code generator polynomials mentioned above are: 65, 57, 71, 73, 75, 53, 57, 47, 65, 57, 75 and 73, respectively. In a case where component code generator vectors are represented in binary, the component code generator vectors are {1, 1, 0, 1, 0, 1}, {1, 0, 1, 1, 1, 1}, {1, 1, 1, 0, 0, 1}, {1, 1, 1, 0, 1, 1}, {1, 1, 1, 1, 0, 1}, {1, 0, 1, 0, 1, 1}, {1, 0, 1, 1, 1, 1}, {1, 0, 0, 1, 1, 1}, {1, 1, 0, 1, 0, 1}, {1, 0, 1, 1, 1, 1}, {1, 1, 1, 1, 0, 1}, and {1, 1, 0, 1, 1, 1}, respectively. Furthermore, the transmitting end may determine the T component code generator polynomials for the convolutional encoding from the set of component code generator polynomials mentioned above. In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an implementation 13, a value of the constraint length of the convolutional encoding is 8. In this case, the number of required shift registers may be a difference between 8 and 1 (i.e., 8 - 1 = 7), and the highest degree of the set of preset component code generator polynomials is 7. The set of preset component code generator polynomials includes at least one of the following component code generator polynomials:

$$g_0(D) = 1 + D^2 + D^4 + D^5 + D^7;$$

$$g_1(D) = 1 + D^1 + D^2 + D^3 + D^6 + D^7;$$

$$g_2(D) = 1 + D^3 + D^5 + D^6 + D^7;$$

$$g_3(D) = 1 + D^1 + D^3 + D^4 + D^5 + D^6 + D^7;$$

$$g_4(D) = 1 + D^1 + D^2 + D^4 + D^7;$$

$$g_5(D) = 1 + D^2 + D^3 + D^4 + D^5 + D^7;$$

$$g_6(D) = 1 + D^1 + D^2 + D^4 + D^6 + D^7;$$

$$g_7(D) = 1 + D^2 + D^5 + D^6 + D^7;$$

$$g_8(D) = 1 + D^1 + D^3 + D^5 + D^6 + D^7;$$

$$g_9(D) = 1 + D^1 + D^2 + D^5 + D^7;$$

$$g_{10}(D) = 1 + D^1 + D^2 + D^3 + D^4 + D^6 + D^7;$$

or

$$g_{11}(D) = 1 + D^2 + D^5 + D^6 + D^7.$$

Octal numbers corresponding to the component code generator polynomials mentioned above are 255, 363, 227, 337, 351, 275, 353, 247, 327, 345, 373 and 247, respectively. In a case where component code generator vectors are represented in binary, the component code generator vectors are: {1, 0, 1, 0, 1, 1, 0, 1}, {1, 1, 1, 1, 0, 0, 1, 1}, {1, 0, 0, 1, 0, 1, 1, 1}, {1, 1, 0, 1, 1, 1, 1, 1}, {1, 1, 1, 0, 1, 0, 0, 1}, {1, 0, 1, 1, 1, 1, 0, 1}, {1, 1, 1, 0, 1, 0, 1, 1}, {1, 0, 1, 0, 0, 1, 1, 1}, {1, 1, 0, 1, 0, 1, 1, 1}, {1, 1, 1, 0, 0, 1, 0, 1}, {1, 1, 1, 1, 1, 0, 1, 1}, and {1, 0, 1, 0, 0, 1, 1, 1}, respectively.

Furthermore, the transmitting end may determine the T component code generator polynomials for the convolutional encoding from the set of component code generator polynomials mentioned above. A value of T may be 2, 3, 4, 5, 6, 7, 8, 10, or 12.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^2 + D^4 + D^5 + D^7$ and $g_1(D) = 1 + D^1 + D^2 + D^3 + D^6 + D^7$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^2 + D^4 + D^5 + D^7$, $g_1(D) = 1 + D^1 + D^2 + D^3 + D^6 + D^7$, and $g_2(D) = 1 + D^3 + D^5 + D^6 + D^7$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^2 + D^4 + D^5 + D^7$, $g_1(D) = 1 + D^1 + D^2 + D^3 + D^6 + D^7$, and $g_2(D) = 1 + D^3 + D^5 + D^6 + D^7$ are used for the convolutional encoding to obtain the encoded bit sequence.

In yet another example, the convolutional encoding uses at least five of the 12 generator polynomials mentioned above for encoding, so as to obtain the encoded bit sequence. For example, at least the generator polynomials $g_0(D) = 1 +$

$D^2 + D^4 + D^5 + D^7$, $g_1(D) = 1 + D^1 + D^2 + D^3 + D^6 + D^7$, $g_2(D) = 1 + D^3 + D^5 + D^6 + D^7$, $g_3(D) = 1 + D^1 + D^3 + D^4 + D^5 + D^6 + D^7$, and $g_4(D) = 1 + D^1 + D^2 + D^4 + D^7$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^2 + D^4 + D^5 + D^7$, $g_1(D) = 1 + D^1 + D^2 + D^3 + D^6 + D^7$, $g_2(D) = 1 + D^3 + D^5 + D^6 + D^7$, $g_3(D) = 1 + D^1 + D^3 + D^4 + D^5 + D^6 + D^7$, $g_4(D) = 1 + D^1 + D^2 + D^4 + D^7$, and $g_5(D) = 1 + D^2 + D^3 + D^4 + D^5 + D^7$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^2 + D^4 + D^5 + D^7$, $g_1(D) = 1 + D^1 + D^2 + D^3 + D^6 + D^7$, $g_2(D) = 1 + D^3 + D^5 + D^6 + D^7$, $g_3(D) = 1 + D^1 + D^3 + D^4 + D^5 + D^6 + D^7$, $g_4(D) = 1 + D^1 + D^2 + D^4 + D^7$, $g_5(D) = 1 + D^2 + D^3 + D^4 + D^5 + D^7$, $g_6(D) = 1 + D^1 + D^2 + D^4 + D^6 + D^7$, and $g_7(D) = 1 + D^2 + D^5 + D^6 + D^7$ are used for the convolutional encoding to obtain the encoded bit sequence.

In addition, the information bit sequence is $b_0$, $b_1$, $b_2$, $b_3$, ..., $b_{K-1}$, K is the length of the information bit sequence, and then for the specific process of performing convolutional encoding according to the component code generator polynomials determined in the examples mentioned above, reference may be made to the specific description of the convolutional encoding process in the implementation 1, and details will not be repeated herein.

In some embodiments, the set of preset component code generator polynomials may further include at least one of the following component code generator polynomials:

$$g_0(D) = 1 + D^2 + D^3 + D^5 + D^7;$$

$$g_1(D) = 1 + D^1 + D^4 + D^5 + D^6 + D^7;$$

$$g_2(D) = 1 + D^1 + D^2 + D^4 + D^7;$$

$$g_3(D) = 1 + D^1 + D^2 + D^3 + D^4 + D^6 + D^7;$$

$$g_4(D) = 1 + D^3 + D^5 + D^6 + D^7;$$

$$g_5(D) = 1 + D^2 + D^3 + D^4 + D^5 + D^7;$$

$$g_6(D) = 1 + D^1 + D^3 + D^5 + D^6 + D^7;$$

$$g_7(D) = 1 + D^1 + D^2 + D^5 + D^7;$$

$$g_8(D) = 1 + D^1 + D^2 + D^4 + D^6 + D^7;$$

$$g_9(D) = 1 + D^2 + D^5 + D^6 + D^7;$$

$$g_{10}(D) = 1 + D^1 + D^3 + D^4 + D^5 + D^6 + D^7;$$

or

$$g_{11}(D) = 1 + D^1 + D^2 + D^5 + D^7.$$

Octal numbers corresponding to the component code generator polynomials mentioned above are: 265, 317, 351, 373, 227, 275, 327, 345, 353, 247, 337 and 345, respectively. In a case where component code generator vectors are represented in binary, the component code generator vectors are {1, 0, 1, 1, 0, 1, 0, 1}, {1, 1, 0, 0, 1, 1, 1, 1}, {1, 1, 1, 0, 1, 0, 0, 1}, {1, 1, 1, 1, 1, 0, 1, 1}, {1, 0, 0, 1, 0, 1, 1, 1}, {1, 0, 1, 1, 1, 1, 0, 1}, {1, 1, 0, 1, 0, 1, 1, 1}, {1, 1, 1, 0, 0, 1, 0, 1}, {1, 1, 1, 0, 1, 0, 1, 1}, {1, 0, 1, 0, 0, 1, 1, 1}, {1, 1, 0, 1, 1, 1, 1, 1}, and {1, 1, 1, 0, 0, 1, 0, 1}, respectively.

Furthermore, the transmitting end may determine the T component code generator polynomials for the convolutional encoding from the set of component code generator polynomials mentioned above. A value of T may be 2, 3, 4, 5, 6, 7, 8, 10, or 12.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^2 + D^3 + D^5 + D^7$ and $g_1(D) = 1 + D^1 + D^4 + D^5 + D^6 + D^7$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^2 + D^3 + D^5 + D^7$, $g_1(D) = 1 + D^1 + D^4 + D^5 + D^6 + D^7$, and $g_2(D) = 1 + D^1 + D^2 + D^4 + D^7$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^2 + D^3 + D^5 + D^7$, $g_1(D) = 1 + D^1 + D^4 + D^5 + D^6 + D^7$, $g_2(D) = 1 + D^1 + D^2 + D^4 + D^7$, and $g_3(D) = 1 + D^1 + D^2 + D^3 + D^4 + D^6 + D^7$ are used for the convolutional encoding to obtain the encoded bit sequence.

In yet another example, the convolutional encoding uses at least five of the 12 generator polynomials mentioned above for encoding, so as to obtain the encoded bit sequence. For example, at least the generator polynomials $g_0(D) = 1 + D^2 + D^3 + D^5 + D^7$, $g_1(D) = 1 + D^1 + D^4 + D^5 + D^6 + D^7$, $g_2(D) = 1 + D^1 + D^2 + D^4 + D^7$, $g_3(D) = 1 + D^1 + D^2 + D^3 + D^4 + D^6 + D^7$, and $g_4(D) = 1 + D^3 + D^5 + D^6$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^2 + D^3 + D^5 + D^7$, $g_1(D) = 1 + D^1 + D^4 + D^5 + D^6 + D^7$, $g_2(D) = 1 + D^1 + D^2 + D^4 + D^7$, $g_3(D) = 1 + D^1 + D^2 + D^3 + D^4 + D^6 + D^7$, $g_4(D) = 1 + D^3 + D^5 + D^6$, and $g_5(D) = 1 + D^2 + D^3 + D^4 + D^5 + D^7$ are used for the convolutional encoding to obtain the encoded bit sequence.

In an implementation 14, a value of the constraint length of the convolutional encoding is 10. In this case, the number of required shift registers may be a difference between 10 and 1 (i.e., 10 - 1 = 9), and the highest degree of the set of preset component code generator polynomials is 9. The set of preset component code generator polynomials includes at least one of the following component code generator polynomials:

$$g_0(D) = 1 + D^1 + D^3 + D^5 + D^6 + D^8 + D^9;$$

$$g_1(D) = 1 + D^2 + D^3 + D^4 + D^5 + D^6 + D^9;$$

$$g_2(D) = 1 + D^2 + D^6 + D^7 + D^8 + D^9;$$

$$g_3(D) = 1 + D^1 + D^2 + D^4 + D^7 + D^8 + D^9;$$

$$g_4(D) = 1 + D^3 + D^5 + D^6 + D^7 + D^9;$$

$$g_5(D) = 1 + D^1 + D^2 + D^3 + D^5 + D^6 + D^9;$$

$$g_6(D) = 1 + D^1 + D^3 + D^5 + D^7 + D^8 + D^9;$$

$$g_7(D) = 1 + D^2 + D^5 + D^6 + D^7 + D^8 + D^9;$$

$$g_8(D) = 1 + D^1 + D^3 + D^4 + D^7 + D^9;$$

$$g_9(D) = 1 + D^1 + D^2 + D^3 + D^4 + D^6 + D^8 + D^9;$$

$$g_{10}(D) = 1 + D^1 + D^3 + D^4 + D^5 + D^6 + D^9;$$

or

$$g_{11}(D) = 1 + D^3 + D^5 + D^6 + D^7 + D^9.$$

Octal numbers corresponding to the component code generator polynomials mentioned above are 1533, 1371, 1217, 1647, 1135, 1731, 1527, 1237, 1545, 1753, 1571, and 1135, respectively. In a case where component code generator vectors are represented in binary, the component code generator vectors are: {1, 1, 0, 1, 0, 1, 1, 0, 1, 1}, {1, 0, 1, 1, 1, 1, 1, 0, 0, 1}, {1, 0, 1, 0, 0, 0, 1, 1, 1, 1}, {1, 1, 1, 0, 1, 0, 0, 1, 1, 1}, {1, 0, 0, 1, 0, 1, 1, 1, 0, 1}, {1, 1, 1, 1, 0, 1, 1, 0, 0, 1}, {1, 1, 0, 1, 0, 1, 0, 1, 1, 1}, {1, 0, 1, 0, 0, 1, 1, 1, 1, 1}, {1, 1, 0, 1, 1, 0, 0, 1, 0, 1}, {1, 1, 1, 1, 1, 0, 1, 0, 1, 1}, {1, 1, 0, 1, 1, 1, 1, 0, 0, 1}, and {1, 0, 0, 1, 0, 1, 1, 1, 0, 1}, respectively.

Furthermore, the transmitting end may determine the T component code generator polynomials for the convolutional encoding from the set of component code generator polynomials mentioned above. A value of T may be 2, 3, 4, 5, 6, 7, 8, 10, or 12.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^1 + D^3 + D^5 + D^6 + D^8 + D^9$ and $g_1(D) = 1 + D^2 + D^3 + D^4 + D^5 + D^6 + D^9$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^1 + D^3 + D^5 + D^6 + D^8 + D^9$, $g_1(D) = 1 + D^2 + D^3 + D^4 + D^5 + D^6 + D^9$, and $g_2(D) = 1 + D^2 + D^6 + D^7 + D^8 + D^9$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^1 + D^3 + D^5 + D^6 + D^8 + D^9$, $g_1(D) = 1 + D^2 + D^3 + D^4 + D^5 + D^6 + D^9$, $g_2(D) = 1 + D^2 + D^6 + D^7 + D^8 + D^9$, and $g_3(D) = 1 + D^1 + D^2 + D^4 + D^7 + D^8 + D^9$ are used for the convolutional encoding to obtain the encoded bit sequence.

In yet another example, the convolutional encoding uses at least five of the 12 generator polynomials mentioned above for encoding, so as to obtain the encoded bit sequence. For example, at least the generator polynomials $g_0(D) = 1 + D^1 + D^3 + D^5 + D^6 + D^8 + D^9$, $g_1(D) = 1 + D^2 + D^3 + D^4 + D^5 + D^6 + D^9$, $g_2(D) = 1 + D^2 + D^6 + D^7 + D^8 + D^9$, $g_3(D) = 1 + D^1 + D^2 + D^4 + D^7 + D^8 + D^9$, and $g_4(D) = 1 + D^3 + D^5 + D^6 + D^7 + D^9$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^1 + D^3 + D^5 + D^6 + D^8 + D^9$, $g_1(D) = 1 + D^2 + D^3 + D^4 + D^5 + D^6 + D^9$, $g_2(D) = 1 + D^2 + D^6 + D^7 + D^8 + D^9$, $g_3(D) = 1 + D^1 + D^2 + D^4 + D^7 + D^8 + D^9$, $g_4(D) = 1 + D^3 + D^5 + D^6 + D^7 + D^9$, and $g_5(D) = 1 + D^1 + D^2 + D^3 + D^5 + D^6 + D^9$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^1 + D^3 + D^5 + D^6 + D^8 + D^9$, $g_1(D) = 1 + D^2 + D^3 + D^4 + D^5 + D^6 + D^9$, $g_2(D) = 1 + D^2 + D^6 + D^7 + D^8 + D^9$, $g_3(D) = 1 + D^1 + D^2 + D^4 + D^7 + D^8 + D^9$, $g_4(D) = 1 + D^3 + D^5 + D^6 + D^7 + D^9$, $g_5(D) = 1 + D^1 + D^2 + D^3 + D^5 + D^6 + D^9$, $g_6(D) = 1 + D^1 + D^3 + D^5 + D^7 + D^8 + D^9$, and $g_7(D) = 1 + D^2 + D^5 + D^6 + D^7 + D^8 + D^9$ are used for the convolutional encoding to obtain the encoded bit sequence.

In addition, the information bit sequence is $b_0, b_1, b_2, b_3, ..., b_{K-1}$, K is the length of the information bit sequence, and then for the specific process of performing the convolutional encoding according to the component code generator polynomials determined in the examples mentioned above, reference may be made to the specific description of the convolutional encoding process in the implementation 1, and details will not be repeated herein.

In some embodiments, the set of preset component code generator polynomials may further include at least one of the following component code generator polynomials:

$$g_0(D) = 1 + D^1 + D^3 + D^4 + D^6 + D^8 + D^9;$$

$$g_1(D) = 1 + D^3 + D^4 + D^5 + D^6 + D^7 + D^9;$$

$$g_2(D) = 1 + D^1 + D^2 + D^3 + D^7 + D^9;$$

$$g_3(D) = 1 + D^1 + D^2 + D^5 + D^7 + D^8 + D^9;$$

$$g_4(D) = 1 + D^2 + D^3 + D^4 + D^6 + D^9;$$

$$g_5(D) = 1 + D^3 + D^4 + D^6 + D^7 + D^8 + D^9;$$

$$g_6(D) = 1 + D^1 + D^2 + D^4 + D^6 + D^8 + D^9;$$

$$g_7(D) = 1 + D^1 + D^2 + D^3 + D^4 + D^7 + D^9;$$

$$g_8(D) = 1 + D^2 + D^5 + D^6 + D^8 + D^9;$$

$$g_9(D) = 1 + D^1 + D^3 + D^5 + D^6 + D^7 + D^8 + D^9;$$

$$g_{10}(D) = 1 + D^1 + D^2 + D^3 + D^5 + D^6 + D^9;$$

or

$$g_{11}(D) = 1 + D^2 + D^3 + D^4 + D^6 + D^9.$$

Octal numbers corresponding to the component code generator polynomials mentioned above are: 1553, 1175, 1705, 1627, 1351, 1157, 1653, 1745, 1233, 1537, 1731 and 1351, respectively. In a case where component code generator vectors are represented in binary, the component code generator vectors are {1, 1, 0, 1, 1, 0, 1, 0, 1, 1}, {1, 0, 0, 1, 1, 1, 1, 1, 0, 1}, {1, 1, 1, 1, 0, 0, 0, 1, 0, 1}, {1, 1, 1, 0, 0, 1, 0, 1, 1, 1}, {1, 0, 1, 1, 1, 0, 1, 0, 0, 1}, {1, 0, 0, 1, 1, 0, 1, 1, 1, 1}, {1, 1, 1, 0, 1, 0, 1, 0, 1, 1}, {1, 1, 1, 1, 1, 0, 0, 1, 0, 1}, {1, 0, 1, 0, 0, 1, 1, 0, 1, 1}, {1, 1, 0, 1, 0, 1, 1, 1, 1, 1}, {1, 1, 1, 1, 0, 1, 1, 0, 0, 1}, and {1, 0, 1, 1, 1, 0, 1, 0, 0, 1}, respectively.

Furthermore, the transmitting end may determine the T component code generator polynomials for the convolutional encoding from the set of component code generator polynomials mentioned above. A value of T may be 2, 3, 4, 5, 6, 7, 8, 10, or 12. In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an implementation 15, a value of the constraint length of the convolutional encoding is 11. In this case, the number of required shift registers may be a difference between 11 and 1 (i.e., 11 - 1 = 10), and the highest degree of the set of preset component code generator polynomials is 10. The set of preset component code generator polynomials includes at least one of the following component code generator polynomials:

$$g_0(D) = 1 + D^3 + D^5 + D^6 + D^7 + D^{10};$$

$$g_1(D) = 1 + D^1 + D^3 + D^4 + D^5 + D^6 + D^{10};$$

$$g_2(D) = 1 + D^1 + D^2 + D^4 + D^5 + D^6 + D^8 + D^{10};$$

$$g_3(D) = 1 + D^1 + D^4 + D^5 + D^6 + D^7 + D^9 + D^{10};$$

$$g_4(D) = 1 + D^2 + D^4 + D^7 + D^8 + D^9 + D^{10};$$

$$g_5(D) = 1 + D^2 + D^3 + D^4 + D^5 + D^7 + D^8 + D^{10};$$

$$g_6(D) = 1 + D^3 + D^4 + D^5 + D^7 + D^9 + D^{10};$$

$$g_7(D) = 1 + D^1 + D^3 + D^4 + D^5 + D^6 + D^7 + D^{10};$$

$$g_8(D) = 1 + D^2 + D^5 + D^6 + D^8 + D^9 + D^{10};$$

$$g_9(D) = 1 + D^2 + D^4 + D^7 + D^8 + D^9 + D^{10};$$

$$g_{10}(D) = 1 + D^1 + D^2 + D^3 + D^4 + D^6 + D^7 + D^{10};$$

or

$$g_{11}(D) = 1 + D^1 + D^2 + D^3 + D^5 + D^7 + D^9 + D^{10}.$$

Octal numbers corresponding to the component code generator polynomials mentioned above are 2271, 3361, 3565, 3173, 2517, 2755, 2353, 3371, 2467, 2517, 3731 and 3653, respectively. In a case where component code generator vectors are represented in binary, the component code generator vectors are: {1, 0, 0, 1, 0, 1, 1, 1, 0, 0, 1}, {1, 1, 0, 1, 1, 1, 1, 0, 0, 0, 1}, {1, 1, 1, 0, 1, 1, 1, 0, 1, 0, 1}, {1, 1, 0, 0, 1, 1, 1, 1, 0, 1, 1}, {1, 0, 1, 0, 1, 0, 0, 1, 1, 1, 1}, {1, 0, 1, 1, 1, 1, 0, 1, 1, 0, 1}, {1, 0, 0, 1, 1, 1, 0, 1, 0, 1, 1}, {1, 1, 0, 1, 1, 1, 1, 1, 0, 0, 1}, {1, 0, 1, 0, 0, 1, 1, 0, 1, 1, 1}, {1, 0, 1, 0, 1, 0, 0, 1, 1, 1, 1}, {1, 1, 1, 1, 1, 0, 1, 1, 0, 0, 1}, and {1, 1, 1, 1, 0, 1, 0, 1, 0, 1, 1}, respectively.

Furthermore, the transmitting end may determine the T component code generator polynomials for the convolutional encoding from the set of component code generator polynomials mentioned above. A value of T may be 2, 3, 4, 5, 6, 7, 8, 10, or 12.

In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In an example, the convolutional encoding uses at least two of the 12 generator polynomials mentioned above for encoding, so as to obtain the encoded bit sequence. For example, at least the generator polynomials $g_0(D) = 1 + D^3 + D^5 + D^6 + D^7 + D^{10}$ and $g_1(D) = 1 + D^1 + D^3 + D^4 + D^5 + D^6 + D^{10}$ are used for the convolutional encoding to obtain the encoded bit sequence.

In another example, the convolutional encoding uses at least three of the 12 generator polynomials mentioned above for encoding, so as to obtain the encoded bit sequence. For example, at least the generator polynomials $g_0(D) = 1 + D^3 + D^5 + D^6 + D^7 + D^{10}$, $g_1(D) = 1 + D^1 + D^3 + D^4 + D^5 + D^6 + D^{10}$, and $g_2(D) = 1 + D^1 + D^2 + D^4 + D^5 + D^6 + D^8 + D^{10}$ are used for the convolutional encoding to obtain the encoded bit sequence.

In yet another example, the convolutional encoding uses at least four of the 12 generator polynomials mentioned above for encoding, so as to obtain the encoded bit sequence. For example, at least the generator polynomials $g_0(D) = 1 + D^3 + D^5 + D^6 + D^7 + D^{10}$, $g_1(D) = 1 + D^1 + D^3 + D^4 + D^5 + D^6 + D^{10}$, $g_2(D) = 1 + D^1 + D^2 + D^4 + D^5 + D^6 + D^8 + D^{10}$, and $g_3(D) = 1 + D^1 + D^4 + D^5 + D^6 + D^7 + D^9 + D^{10}$ are used for the convolutional encoding to obtain the encoded bit sequence.

In yet another example, the convolutional encoding uses at least five of the 12 generator polynomials mentioned above for encoding, so as to obtain the encoded bit sequence. For example, at least the generator polynomials $g_0(D) = g_0(D) = 1 + D^3 + D^5 + D^6 + D^7 + D^{10}$, $g_1(D) = 1 + D^1 + D^3 + D^4 + D^5 + D^6 + D^{10}$, $g_2(D) = 1 + D^1 + D^2 + D^4 + D^5 + D^6 + D^8 + D^{10}$, $g_3(D) = 1 + D^1 + D^4 + D^5 + D^6 + D^7 + D^9 + D^{10}$, and $g_4(D) = 1 + D^2 + D^4 + D^7 + D^8 + D^9 + D^{10}$ are used for the convolutional encoding to obtain the encoded bit sequence.

In yet another example, the convolutional encoding uses at least six of the 12 generator polynomials mentioned above for encoding, so as to obtain the encoded bit sequence. For example, at least the generator polynomials $g_0(D) = 1 + D^3 + D^5 + D^6 + D^7 + D^{10}$, $g_1(D) = 1 + D^1 + D^3 + D^4 + D^5 + D^6 + D^{10}$, $g_2(D) = 1 + D^1 + D^2 + D^4 + D^5 + D^6 + D^8 + D^{10}$, $g_3(D) = 1 + D^1 + D^4 + D^5 + D^6 + D^7 + D^9 + D^{10}$, $g_4(D) = 1 + D^2 + D^4 + D^7 + D^8 + D^9 + D^{10}$, and $g_5(D) = 1 + D^2 + D^3 + D^4 + D^5 + D^7 + D^8 + D^{10}$ are used for the convolutional encoding to obtain the encoded bit sequence.

In yet another example, the convolutional encoding uses at least eight of the 12 generator polynomials mentioned above for encoding, so as to obtain the encoded bit sequence. For example, at least the generator polynomials $g_0(D) = 1 + D^3 + D^5 + D^6 + D^7 + D^{10}$, $g_1(D) = 1 + D^1 + D^3 + D^4 + D^5 + D^6 + D^{10}$, $g_2(D) = 1 + D^1 + D^2 + D^4 + D^5 + D^6 + D^8 + D^{10}$, $g_3(D) = 1 + D^1$

$+ D^4 + D^5 + D^6 + D^7 + D^9 + D^{10}$, $g_4(D) = 1 + D^2 + D^4 + D^7 + D^8 + D^9 + D^{10}$, $g_5(D) = 1 + D^2 + D^3 + D^4 + D^5 + D^7 + D^8 + D^{10}$, $g_6(D) = 1 + D^3 + D^4 + D^5 + D^7 + D^9 + D^{10}$, and $g_7(D) = 1 + D^1 + D^3 + D^4 + D^5 + D^6 + D^7 + D^{10}$ are used for the convolutional encoding to obtain the encoded bit sequence.

In addition, the information bit sequence is $b_0$, $b_1$, $b_2$, $b_3$, ..., $b_{K-1}$, K is the length of the information bit sequence, and then for the specific process of performing convolutional encoding according to the component code generator polynomials determined in the examples mentioned above, reference may be made to the specific description of the convolutional encoding process in the implementation 1, and details will not be repeated herein.

In some embodiments, the set of preset component code generator polynomials may further include at least one of the following component code generator polynomials:

$$g_0(D) = 1 + D^3 + D^4 + D^5 + D^7 + D^{10};$$

$$g_1(D) = 1 + D^4 + D^5 + D^6 + D^7 + D^9 + D^{10};$$

$$g_2(D) = 1 + D^2 + D^4 + D^5 + D^6 + D^8 + D^9 + D^{10};$$

$$g_3(D) = 1 + D^1 + D^3 + D^4 + D^5 + D^6 + D^9 + D^{10};$$

$$g_4(D) = 1 + D^1 + D^2 + D^3 + D^6 + D^8 + D^{10};$$

$$g_5(D) = 1 + D^2 + D^3 + D^5 + D^6 + D^7 + D^8 + D^{10};$$

$$g_6(D) = 1 + D^1 + D^3 + D^5 + D^6 + D^7 + D^{10};$$

$$g_7(D) = 1 + D^3 + D^4 + D^5 + D^6 + D^7 + D^9 + D^{10};$$

$$g_8(D) = 1 + D^1 + D^2 + D^4 + D^5 + D^8 + D^{10};$$

$$g_9(D) = 1 + D^1 + D^2 + D^3 + D^6 + D^8 + D^{10};$$

$$g_{10}(D) = 1 + D^3 + D^4 + D^6 + D^7 + D^8 + D^9 + D^{10};$$

or

$$g_{11}(D) = 1 + D^1 + D^3 + D^5 + D^7 + D^8 + D^9 + D^{10}.$$

Octal numbers corresponding to the component code generator polynomials mentioned above are: 2351, 2173, 2567, 3363, 3625, 2675, 3271, 2373, 3545, 3625, 2337 and 3257, respectively. In a case where component code generator vectors are represented in binary, the component code generator vectors are {1, 0, 0, 1, 1, 1, 0, 1, 0, 0, 1}, {1, 0, 0, 0, 1, 1, 1, 1, 0, 1, 1}, {1, 0, 1, 0, 1, 1, 1, 0, 1, 1, 1}, {1, 1, 0, 1, 1, 1, 1, 0, 0, 1, 1}, {1, 1, 1, 1, 0, 0, 1, 0, 1, 0, 1}, {1, 0, 1, 1, 0, 1, 1, 1, 1, 0, 1}, {1, 1, 0, 1, 0, 1, 1, 0, 0, 1}, {1, 0, 0, 1, 1, 1, 1, 0, 1, 1}, {1, 1, 1, 0, 1, 1, 0, 0, 1, 0, 1}, {1, 1, 1, 1, 0, 0, 1, 0, 1, 0, 1}, {1, 0, 0, 1, 1, 0, 1, 1, 1, 1, 1}, and {1, 1, 0, 1, 0, 1, 0, 1, 1, 1, 1}, respectively.

Furthermore, the transmitting end may determine the T component code generator polynomials for the convolutional encoding from the set of component code generator polynomials mentioned above. A value of T may be 2, 3, 4, 5, 6, 7, 8, 10, or 12. In some embodiments, the T component code generator polynomials used for the convolutional encoding include at least the first J component code generator polynomials in the 12 generator polynomials mentioned above. A value of J may be 2, 3, 4, 5, 6, 7, 8, 9, 10, or 12, and J is an integer less than or equal to T.

In S103, all or some of bits in the encoded bit sequence are sent.

In some embodiments, the transmitting end may, each time 1 bit of the information bit sequence is inputted, perform the convolutional encoding on this 1 bit to obtain T bits, and then immediately send the generated T bits.

Alternatively, the transmitting end may perform the convolutional encoding on all bits of the information bit sequence to obtain K*T bits, and then send the K*T bits in sequence.

Alternatively, the transmitting end may perform the convolutional encoding on all bits of the information bit sequence to obtain K*T bits, and then interleave or partially interleave each component code output bit sequence (each of which has a length of K bits), and send interleaved encoded output bit of each component code.

Alternatively, the transmitting end may perform the convolutional encoding on all bits of the information bit sequence to obtain K*T bits, and then interleave or partially interleave each component code output bit sequence, and next perform bit selection to obtain a rate-matched bit sequence, and send the rate-matched bit sequence.

Based on the embodiments mentioned above, the method may perform the convolutional encoding on the information bit sequence according to the preset component code generator polynomials, thereby obtaining a bit sequence to be transmitted. The present disclosure further provides a plurality of possible implementations of preset component code generator polynomials with different convolutional encoding constraint lengths. Furthermore, since the number of non-zero coefficients in the component code generator polynomials provided in the present disclosure is small, the weight of the component code is reduced and the number of XOR gates is also reduced by using the component code generator polynomials provided in the embodiments of the present disclosure for the convolutional encoding, so that the complexity of convolutional encoding may be reduced and the robustness of data communication may be increased.

In some embodiments, a decoding method is also provided in the present disclosure. As shown in FIG. 5, the method includes the following steps.

In S201, all or some of bits in an encoded bit sequence are received.

A receiving end receives all or some of the bits in the encoded bit sequence and may perform a decoding operation on all or some of the bits in the encoded bit sequence. Considering the communication system 100 shown in FIG. 1 as an example, the receiving end may be the terminal device or the network device in the communication system 100. During the communication process, if the network device sends data to the terminal device and the terminal device receives the data sent by the network device, the network device may be referred to as a transmitting end. Correspondingly, the terminal device may be referred to as a receiving end.

In S202, convolutional decoding is performed on the all or some of the bits in the encoded bit sequence according to T component code generator polynomials, so as to obtain an information bit sequence.

Herein, T is an integer greater than 1. For example, a value of T includes 2, 3, 4, 6, 8, 10 or 12.

In some embodiments, the receiving end may further receive information related to the encoded bit sequence. For example, the related information may include T component code generator polynomials.

In some embodiments, the receiving end may also be pre-configured with the T component code generator polynomials. The T component code generator polynomials are the same as the T component code generator polynomials used by the transmitting end to perform the convolutional encoding to obtain the encoded bit sequence.

In some embodiments, a constraint length of the convolutional encoding is determined according to the highest degree of polynomials of the T component code generator polynomials. For example, the constraint length of the convolutional encoding may be a sum of 1 and the highest degree of the polynomials of the T component code generator polynomials.

In some embodiments, the constraint length of the convolutional encoding may be at least one of: 5, 6, 7, 8, 9, 10, or 11. In an example, the constraint lengths of the convolutional encoding are 7 and 9. In another example, the constraint lengths of the convolutional encoding are 5 and 9. In yet another example, the constraint lengths of the convolutional encoding are equal to 7 and 11. In yet another example, the constraint lengths of the convolutional encoding are 7, 9, and 11.

In an example, in a case where a value of the convolutional code is 7, the number of required shift registers may be a difference between 7 and 1 (i.e., 7 - 1 = 6), and the highest degree of the set of preset component code generator polynomials is 6. The T component code generator polynomials may be determined from the following component code generator polynomials:

$$g_0(D) = 1 + D^1 + D^3 + D^4 + D^6;$$

$$g_1(D) = 1 + D^3 + D^4 + D^5 + D^6;$$

$$g_2(D) = 1 + D^2 + D^4 + D^5 + D^6;$$

$$g_3(D) = 1 + D^1 + D^2 + D^3 + D^6;$$

$$g_4(D) = 1 + D^2 + D^3 + D^4 + D^6;$$

$$g_5(D) = 1 + D^1 + D^2 + D^3 + D^5 + D^6;$$

$$g_6(D) = 1 + D^2 + D^3 + D^4 + D^6;$$

$$g_7(D) = 1 + D^1 + D^4 + D^6;$$

$$g_8(D) = 1 + D^1 + D^3 + D^4 + D^5 + D^6;$$

$$g_9(D) = 1 + D^2 + D^3 + D^4 + D^6;$$

$$g_{10}(D) = 1 + D^3 + D^4 + D^5 + D^6;$$

$$g_{11}(D) = 1 + D^2 + D^3 + D^4 + D^6.$$

In another example, in a case where a value of the convolutional code is 9, the number of required shift registers may be a difference between 9 and 1 (i.e., 9 - 1 = 8), and the highest degree of the set of preset component code generator polynomials is 8. The T component code generator polynomials may be determined from the following component code generator polynomials:

$$g_0(D) = 1 + D^2 + D^3 + D^4 + D^8;$$

$$g_1(D) = 1 + D^1 + D^2 + D^3 + D^5 + D^7 + D^8;$$

$$g_2(D) = 1 + D^1 + D^2 + D^5 + D^6 + D^8;$$

$$g_3(D) = 1 + D^2 + D^4 + D^7 + D^8;$$

$$g_4(D) = 1 + D^1 + D^2 + D^4 + D^5 + D^6 + D^7 + D^8;$$

$$g_5(D) = 1 + D^3 + D^5 + D^6 + D^8;$$

$$g_6(D) = 1 + D^1 + D^2 + D^3 + D^5 + D^7 + D^8;$$

$$g_7(D) = 1 + D^1 + D^2 + D^3 + D^6 + D^8;$$

$$g_8(D) = 1 + D^1 + D^3 + D^5 + D^6 + D^7 + D^8;$$

$$g_9(D) = 1 + D^1 + D^3 + D^4 + D^5 + D^8;$$

$$g_{10}(D) = 1 + D^1 + D^2 + D^3 + D^6 + D^8;$$

$$g_{11}(D) = 1 + D^1 + D^3 + D^5 + D^6 + D^7 + D^8.$$

In yet another example, in a case where a value of the convolutional code is 5, the number of required shift registers may be a difference between 5 and 1 (i.e., 5 - 1 = 4), and the highest degree of the set of preset component code generator polynomials is 4. The T component code generator polynomials may be determined from the following component code generator polynomials:

$$g_0(D) = 1 + D^3 + D^4;$$

$$g_1(D) = 1 + D^1 + D^2 + D^4;$$

$$g_2(D) = 1 + D^2 + D^3 + D^4;$$

$$g_3(D) = 1 + D^1 + D^3 + D^4;$$

$$g_4(D) = 1 + D^1 + D^2 + D^4;$$

$$g_5(D) = 1 + D^2 + D^3 + D^4;$$

$$g_6(D) = 1 + D^1 + D^2 + D^4;$$

$$g_7(D) = 1 + D^2 + D^3 + D^4;$$

$$g_8(D) = 1 + D^1 + D^2 + D^3 + D^4;$$

$$g_9(D) = 1 + D^2 + D^3 + D^4;$$

$$g_{10}(D) = 1 + D^1 + D^2 + D^4;$$

$$g_{11}(D) = 1 + D^2 + D^3 + D^4.$$

In yet another example, in a case where a value of the convolutional code is 6, the number of required shift registers may be a difference between 6 and 1 (i.e., 6 - 1 = 5), and the highest degree of the set of preset component code generator polynomials is 5. The T component code generator polynomials may be determined from the following component code generator polynomials:

$$g_0(D) = 1 + D^2 + D^4 + D^5;$$

$$g_1(D) = 1 + D^1 + D^2 + D^3 + D^5;$$

$$g_2(D) = 1 + D^3 + D^4 + D^5;$$

$$g_3(D) = 1 + D^1 + D^3 + D^4 + D^5;$$

$$g_4(D) = 1 + D^2 + D^3 + D^4 + D^5;$$

$$g_5(D) = 1 + D^1 + D^3 + D^5;$$

$$g_6(D) = 1 + D^1 + D^2 + D^3 + D^5;$$

$$g_7(D) = 1 + D^1 + D^2 + D^5;$$

$$g_8(D) = 1 + D^2 + D^4 + D^5;$$

$$g_9(D) = 1 + D^2 + D^3 + D^4 + D^5;$$

$$g_{10}(D) = 1 + D^1 + D^2 + D^3 + D^5;$$

$$g_{11}(D) = 1 + D^1 + D^3 + D^4 + D^5.$$

In yet another example, in a case where a value of the convolutional code is 8, the number of required shift registers may be a difference between 8 and 1 (i.e., 8 - 1 = 7), and the highest degree of the set of preset component code generator polynomials is 7. The T component code generator polynomials may be determined from the following component code generator polynomials:

$$g_0(D) = 1 + D^2 + D^4 + D^5 + D^7;$$

$$g_1(D) = 1 + D^1 + D^2 + D^3 + D^6 + D^7;$$

$$g_2(D) = 1 + D^3 + D^5 + D^6 + D^7;$$

$$g_3(D) = 1 + D^1 + D^3 + D^4 + D^5 + D^6 + D^7;$$

$$g_4(D) = 1 + D^1 + D^2 + D^4 + D^7;$$

$$g_5(D) = 1 + D^2 + D^3 + D^4 + D^5 + D^7;$$

$$g_6(D) = 1 + D^1 + D^2 + D^4 + D^6 + D^7;$$

$$g_7(D) = 1 + D^2 + D^5 + D^6 + D^7;$$

$$g_8(D) = 1 + D^1 + D^3 + D^5 + D^6 + D^7;$$

$$g_9(D) = 1 + D^1 + D^2 + D^5 + D^7;$$

$$g_{10}(D) = 1 + D^1 + D^2 + D^3 + D^4 + D^6 + D^7;$$

$$g_{11}(D) = 1 + D^2 + D^5 + D^6 + D^7.$$

In yet another example, in a case where a value of the convolutional code is 10, the number of required shift registers may be a difference between 10 and 1 (i.e., 10 - 1 = 9), and the highest degree of the set of preset component code generator polynomials is 9. The T component code generator polynomials may be determined from the following component code generator polynomials:

$$g_0(D) = 1 + D^1 + D^3 + D^5 + D^6 + D^8 + D^9;$$

$$g_1(D) = 1 + D^2 + D^3 + D^4 + D^5 + D^6 + D^9;$$

$$g_2(D) = 1 + D^2 + D^6 + D^7 + D^8 + D^9;$$

$$g_3(D) = 1 + D^1 + D^2 + D^4 + D^7 + D^8 + D^9;$$

$$g_4(D) = 1 + D^3 + D^5 + D^6 + D^7 + D^9;$$

$$g_5(D) = 1 + D^1 + D^2 + D^3 + D^5 + D^6 + D^9;$$

$$g_6(D) = 1 + D^1 + D^3 + D^5 + D^7 + D^8 + D^9;$$

$$g_7(D) = 1 + D^2 + D^5 + D^6 + D^7 + D^8 + D^9;$$

$$g_8(D) = 1 + D^1 + D^3 + D^4 + D^7 + D^9;$$

$$g_9(D) = 1 + D^1 + D^2 + D^3 + D^4 + D^6 + D^8 + D^9;$$

$$g_{10}(D) = 1 + D^1 + D^3 + D^4 + D^5 + D^6 + D^9;$$

$$g_{11}(D) = 1 + D^3 + D^5 + D^6 + D^7 + D^9.$$

In yet another example, in a case where a value of the convolutional code is 11, the number of required shift registers may be a difference between 11 and 1 (i.e., 11 - 1 = 10), and the highest degree of the set of preset component code generator polynomials is 10. The T component code generator polynomials may be determined from the following component code generator polynomials:

$$g_0(D) = 1 + D^3 + D^5 + D^6 + D^7 + D^{10};$$

$$g_1(D) = 1 + D^1 + D^3 + D^4 + D^5 + D^6 + D^{10};$$

$$g_2(D) = 1 + D^1 + D^2 + D^4 + D^5 + D^6 + D^8 + D^{10};$$

$$g_3(D) = 1 + D^1 + D^4 + D^5 + D^6 + D^7 + D^9 + D^{10};$$

$$g_4(D) = 1 + D^2 + D^4 + D^7 + D^8 + D^9 + D^{10};$$

$$g_5(D) = 1 + D^2 + D^3 + D^4 + D^5 + D^7 + D^8 + D^{10};$$

$$g_6(D) = 1 + D^3 + D^4 + D^5 + D^7 + D^9 + D^{10};$$

$$g_7(D) = 1 + D^1 + D^3 + D^4 + D^5 + D^6 + D^7 + D^{10};$$

$$g_8(D) = 1 + D^2 + D^5 + D^6 + D^8 + D^9 + D^{10};$$

$$g_9(D) = 1 + D^2 + D^4 + D^7 + D^8 + D^9 + D^{10};$$

$$g_{10}(D) = 1 + D^1 + D^2 + D^3 + D^4 + D^6 + D^7 + D^{10};$$

$$g_{11}(D) = 1 + D^1 + D^2 + D^3 + D^5 + D^7 + D^9 + D^{10}.$$

For the detailed description and implementation of the component code generator polynomials, reference may also be made to the relevant description in the step S102, and details will not be repeated herein.

Based on the embodiments mentioned above, the obtained bit sequence may be decoded according to the T component code generator polynomials. Since the number of non-zero coefficients in the component code generator polynomials provided in the present disclosure is small, and the weight of the component code is reduced, the complexity of the convolutional encoding and decoding during the communication process may be reduced and the robustness of data communication may be increased by using the component code generator polynomials provided in the embodiments of the present disclosure for decoding.

The bit sequence to be transmitted may be obtained by performing the convolutional encoding on the information bit sequence according to the preset component code generator polynomials. The present disclosure further provides a plurality of possible implementations of preset component code generator polynomials with different convolutional encoding constraint lengths. Furthermore, since the number of non-zero coefficients in the component code generator polynomials provided in the present disclosure is small, the weight of the component code is reduced and the number of XOR gates is also reduced by using the component code generator polynomials provided in the embodiments of the present disclosure for convolutional encoding, so that the complexity of convolutional encoding may be reduced and the robustness of data communication may be increased.

The solutions provided in the present disclosure are introduced above in terms of interaction between various nodes. It may be understood that, in order to achieve the functions mentioned above, each node, such as a device or apparatus, includes corresponding hardware structures and/or software modules for implementing various functions. A person skilled in the art will be easy to realize that, by combining algorithm steps of the examples described in the embodiments disclosed herein, the present disclosure may be implemented through hardware or a combination of hardware and computer software. Whether a certain function is performed by the hardware or a way of driving hardware by the computer software depends on a specific application and a design constraint of a technical scheme. A skilled person uses different methods for each specific application to implement the described functions, but such implementation should not be considered beyond the scope of the present disclosure.

FIG. 6 is a schematic diagram showing a structure of an encoding device provided in embodiments of the present disclosure. As shown in FIG. 6, the encoding device 60 includes an acquiring module 601, a processing module 602, and a sending module 603.

In some embodiments, the acquiring module 601 is configured to acquire an information bit sequence. The processing module 602 is configured to perform convolutional encoding on the information bit sequence according to T component code generator polynomials, so as to obtain an encoded bit sequence. T is an integer greater than 1. The sending module 603 is configured to send all or some of bits in the encoded bit sequence.

In some embodiments, the convolutional encoding is achieved by a plurality of shift registers and a plurality of XOR gates. Every two adjacent shift registers of the plurality of shift registers are connected in series.

In some embodiments, the number of shift registers is determined according to the highest degree of the T component code generator polynomials.

In some embodiments, the number of XOR gates is determined according to the number of coefficients of the T component code generator polynomials.

In some embodiments, a constraint length of the convolutional encoding is determined according to the highest degree of polynomials in the T component code generator polynomials.

In some embodiments, the T component code generator polynomials are determined from a set of preset component code generator polynomials.

In some embodiments, the processing module 602 is specifically configured to: perform convolutional encoding on an information bit sequence according to T component code generator polynomials, so as to obtain T component code bit sequences obtained by the T component code generator polynomials, and perform an interleaving process on all or some of the T component code bit sequences, so as to obtain an encoded bit sequence.

In some embodiments, the processing module 602 is specifically configured to: perform convolutional encoding on an information bit sequence according to T component code generator polynomials, so as to obtain T component code bit sequences obtained by the T component code generator polynomials, perform sub-block interleaving on the i-th component code bit sequence to obtain a sub-block interleaved output sequence, i being a non-negative integer less than T, and determine an encoding bit sequence according to the sub-block interleaved output sequence and other component code bit sequences among the T component code bit sequences except the i-th component code bit sequence.

For the detailed description of the acquiring module 601, processing module 602 and sending module 603, as well as the detailed description of their technical features and beneficial effects, reference may be made to the corresponding embodiments of the encoding method mentioned above, and details will not be repeated herein.

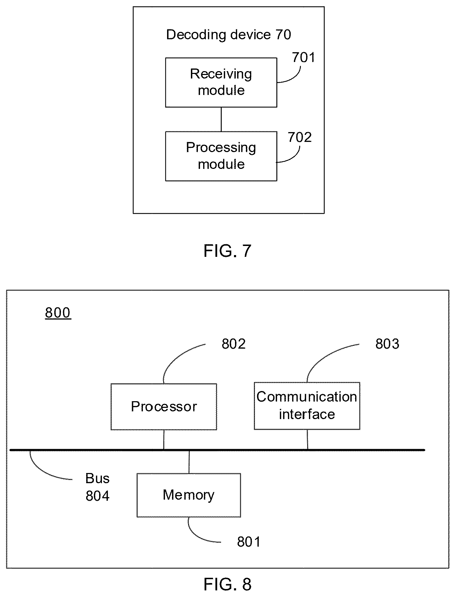

FIG. 7 is a schematic diagram showing a structure of a decoding device provided in embodiments of the present disclosure. As shown in FIG. 7, the decoding device 70 includes a receiving module 701 and a processing module 702.

In some embodiments, the receiving module 701 is configured to receive all or some of bits in an encoded bit sequence. The processing module 702 is configured to perform convolutional decoding on all or some of the bits in the encoded bit sequence according to T component code generator polynomials, so as to obtain an information bit sequence.

In some embodiments, the receiving module 701 is configured to receive information related to the encoded bit sequence.

In some embodiments, the convolutional decoding is achieved according to Viterbi decoding or cyclic redundancy check (CRC)-assisted Viterbi list decoding.

For the detailed description of the receiving module 701 and the processing module 702, and the detailed description of their technical features and the beneficial effects, reference may be made to the corresponding embodiments of the encoding method mentioned above, and details will not be repeated herein.

It will be noted that the modules in FIG. 6 or FIG. 7 may also be referred to as units. For example, the processing module may also be referred to as a processing unit. In addition, in the embodiment shown in FIG. 6 or FIG. 7, the names of the modules may also be different from the names shown in the figure. For example, the acquiring module or the sending module may also be referred to as a communication module.

If the units in FIG. 6 or FIG. 7 are implemented in the form of the software functional module and sold or used as an independent product, they may be stored in a computer-readable storage medium. Based on this understanding, the technical solutions of the embodiments of the present disclosure may be essentially, or a part of the technical solutions of the embodiments of the present disclosure that contributes to the related technology may be, or all or some of the technical solutions may be, embodied in the form of a software product, and the computer software product may be stored in a storage medium, includes a plurality of instructions for enabling a computer device (which may be a personal computer, a server, a network device, etc.) or a processor to perform all or some of the steps of the methods as described in the embodiments of the present disclosure. The storage media for storing the computer software product includes a USB flash disk, a mobile hard disk, a read-only memory (ROM), a random access memory (RAM), a magnetic disk, an optical disk, or other media that may store program codes.

In the case where the functions of the integrated modules mentioned above are implemented in the form of hardware, the embodiments of the present disclosure provide a structural schematic diagram of a communication apparatus. The communication apparatus may be the encoding device or decoding device mentioned above, as shown in FIG. 8. The communication device 800 includes: a processor 802, a communication interface 803, and a bus 804. For example, the communication device 800 may further include a memory 801.

The processor 802 may implement or execute various exemplary logical blocks, modules and circuits described in the disclosed content of the present disclosure. The processor 802 may be a central processing unit, a general-purpose processor, a digital signal processor, an application specific integrated circuit, a field programmable gate array or any other programmable logic device, a transistor logic device, a hardware component, or any combination thereof. The processor 802 may implement or execute various exemplary logical blocks, modules and circuits described in the disclosed content of the present disclosure. The processor 802 may also be a combination that implements computing functions, for example, a combination of one or more microprocessors, or a combination of a digital signal processor (DSP) and a microprocessor.

The communication interface 803 is used to connect to other devices through a communication network. The communication network may be an Ethernet, a wireless access network, a wireless local area network (WLAN), or the like.

The memory 801 may be, but is not limited to, a read-only memory (ROM) or a static storage device of any other type capable of storing static information and instructions, a random access memory (RAM) or a dynamic storage device of any other type capable of storing information and instructions, or an electrically erasable programmable read-only memory (EEPROM), a magnetic disk storage medium or any other magnetic disk storage device, or any other medium capable of being used to carry or store desired program codes and capable of being accessed by a computer, where the desired program codes have instructions or are in the form of data structure.

As a possible implementation, the memory 801 may exist independently of the processor 802, and the memory 801 may be connected to the processor 802 through the bus 804, and is used for storing instructions or program codes. When calling and executing the instructions or program code stored in the memory 801, the processor 802 may achieve the method provided in the embodiments of the present disclosure.

In another possible implementation, the memory 801 may be integrated with the processor 802.

The bus 804 may be an extended industry standard architecture (EISA) bus or the like. The bus 804 may be divided into an address bus, a data bus, and a control bus. For ease of representation, only one bold line is used in FIG. 8, but it does not mean that there is only one bus or one type of bus.

From description of the embodiments mentioned above, those skilled in the art will clearly understand that, for convenience and brevity of description, an example is only given according to the division of functional modules mentioned above. In practical applications, the functions mentioned above are allocated to different functional modules as needed. That is to say, an internal structure of a device or apparatus is divided into different functional modules to perform all or some of the functions described above.

A computer-readable storage medium is further provided in the embodiments of the present disclosure. All or some of the steps in the embodiments of the method described above may be implemented by using computer instructions to instruct related hardware to perform the steps. The program may be stored in the computer-readable storage medium described above. When the program is executed, it may include the steps as in the embodiments of the methods described above. The computer-readable storage medium may be the memory or storage device of any of the embodiments described above. The computer-readable storage medium may also be an external storage device of the device or apparatus, such as a plug-in hard disk, a smart media card (SMC), a secure digital (SD) card, a flash card, equipped on the device or apparatus. Furthermore, the computer-readable storage medium may also include both an internal storage unit of the device or apparatus and an external storage device. The computer-readable storage medium is used to store the computer program mentioned above and other programs and data required by the device or apparatus mentioned above. The computer-readable storage medium may also be used to temporarily store data that has been output or is to be output.

A computer program product is also provided in the embodiments of the present disclosure. The computer program product includes a computer program. When the computer program product is run on a computer, the computer program product enables the computer to execute any one of the methods provided in the embodiments mentioned above.

Although the present disclosure has been described herein in conjunction with various embodiments, other variations of the disclosed embodiments may be understood and achieved by those skilled in the art by viewing the accompanying drawings, the disclosed content, and the claims as provided, during the implementation of the present disclosure for which protection is claimed. In the claims, the word "comprise/comprises/comprising" does not exclude other components or steps, and "a" or "an" does not exclude a case of multiple. A single processor or other unit may achieve functions of several items recited in the claims. The mere fact that certain solutions are recited in mutually different dependent claims does not indicate that these solutions cannot be combined to good effect.

Although the present disclosure has been described in conjunction with specific features and embodiments thereof, it will be apparent that various modifications and combinations may be made thereto without departing from the spirit and scope of the present disclosure. Accordingly, the specification and drawings are merely illustrative of the present disclosure as defined by the appended claims and are deemed to cover any and all modifications, variations, combinations or equivalents within the scope of the present disclosure. Obviously, those skilled in the art may make various changes and modifications to the present disclosure without departing from the spirit and scope of the present disclosure. In this way, if these modifications and variations of the present disclosure fall within the scope of the claims of the present disclosure and their equivalent technologies, the present disclosure is also intended to include these modifications and variations.

The above are only specific embodiments of the present disclosure, but the scope of protection of the present disclosure is not limited thereto, and any variations or replacements within the technical scope of the present disclosure shall fall within the protection scope of the present disclosure. Therefore, the protection scope of the present disclosure shall be subject to the protection scope of the claims.

**Claims**

1. An encoding method, comprises:

   acquiring an information bit sequence;
   performing, according to T component code generator polynomials, convolutional encoding on the information bit sequence, to obtain an encoded bit sequence, T being an integer greater than 1; and
   sending all or some of bits in the encoded bit sequence.

2. The method according to claim 1, wherein a value of T includes 2, 3, 4, 6, 8, 10 or 12.

3. The method according to claim 1, wherein the convolutional encoding is achieved by a plurality of shift registers and a plurality of XOR gates, wherein every two adjacent shift registers of the plurality of shift registers are connected in series.

4. The method according to claim 3, wherein a number of the shift registers is determined according to a highest degree of the T component code generator polynomials.

5. The method according to claim 3, wherein a number of the XOR gates is determined according to a number of coefficients of the T component code generator polynomials.

6. The method according to claim 1, wherein a constraint length of the convolutional encoding is determined according to a highest degree of polynomials of the T component code generator polynomials.

7. The method according to claim 6, wherein a value of the constraint length of the convolutional encoding includes 5, 6, 7, 8, 9, 10 or 11.

8. The method according to claim 1, wherein the T component code generator polynomials are determined from a set of preset component code generator polynomials.

9. The method according to claim 8, wherein a value of a constraint length of the convolutional encoding is 7, and the set of preset component code generator polynomials includes at least one of the following component code generator polynomials:

$$g_0(D) = 1 + D^1 + D^3 + D^4 + D^6;$$

$$g_1(D) = 1 + D^3 + D^4 + D^5 + D^6;$$

$$g_2(D) = 1 + D^2 + D^4 + D^5 + D^6;$$

$$g_3(D) = 1 + D^1 + D^2 + D^3 + D^6;$$

$$g_4(D) = 1 + D^2 + D^3 + D^4 + D^6;$$

$$g_5(D) = 1 + D^1 + D^2 + D^3 + D^5 + D^6;$$

$$g_6(D) = 1 + D^2 + D^3 + D^4 + D^6;$$

$$g_7(D) = 1 + D^1 + D^4 + D^6;$$

$$g_8(D) = 1 + D^1 + D^3 + D^4 + D^5 + D^6;$$

$$g_9(D) = 1 + D^2 + D^3 + D^4 + D^6;$$

$$g_{10}(D) = 1 + D^3 + D^4 + D^5 + D^6;$$

or

$$g_{11}(D) = 1 + D^2 + D^3 + D^4 + D^6.$$

10. The method according to claim 8, wherein a value of a constraint length of the convolutional encoding is 7, and the set of preset component code generator polynomials includes at least one of the following component code generator polynomials:

$$g_0(D) = 1 + D^1 + D^2 + D^3 + D^4 + D^6;$$

$$g_1(D) = 1 + D^2 + D^3 + D^5 + D^6;$$

$$g_2(D) = 1 + D^1 + D^4 + D^6;$$

$$g_3(D) = 1 + D^3 + D^4 + D^5 + D^6;$$

$$g_4(D) = 1 + D^2 + D^4 + D^5 + D^6;$$

$$g_5(D) = 1 + D^1 + D^3 + D^4 + D^5 + D^6;$$

$$g_6(D) = 1 + D^1 + D^2 + D^4 + D^6;$$

$$g_7(D) = 1 + D^1 + D^3 + D^6;$$

$$g_8(D) = 1 + D^2 + D^3 + D^4 + D^5 + D^6;$$

$$g_9(D) = 1 + D^1 + D^3 + D^4 + D^6;$$

$$g_{10}(D) = 1 + D^3 + D^4 + D^5 + D^6;$$

or

$$g_{11}(D) = 1 + D^2 + D^4 + D^5 + D^6.$$

11. The method according to claim 8, wherein a value of a constraint length of the convolutional encoding is 7, and the set of preset component code generator polynomials includes at least one of the following component code generator polynomials:

$$g_0(D) = 1 + D^1 + D^3 + D^4 + D^6;$$

$$g_1(D) = 1 + D^2 + D^3 + D^4 + D^5 + D^6;$$

$$g_2(D) = 1 + D^2 + D^5 + D^6;$$

$$g_3(D) = 1 + D^1 + D^2 + D^3 + D^6;$$

$$g_4(D) = 1 + D^2 + D^4 + D^5 + D^6;$$

$$g_5(D) = 1 + D^1 + D^2 + D^3 + D^5 + D^6;$$

$$g_6(D) = 1 + D^1 + D^2 + D^4 + D^6;$$

$$g_7(D) = 1 + D^3 + D^5 + D^6;$$

$$g_8(D) = 1 + D^1 + D^2 + D^3 + D^4 + D^6;$$

$$g_9(D) = 1 + D^1 + D^3 + D^4 + D^6;$$

$$g_{10}(D) = 1 + D^3 + D^4 + D^5 + D^6;$$

or

$$g_{11}(D) = 1 + D^2 + D^4 + D^5 + D^6.$$

**12.** The method according to claim 1, wherein a value of a constraint length of the convolutional encoding is 7, and the T component code generator polynomials include the following component code generator polynomials:

$$g_0(D) = 1 + D^2 + D^3 + D^5 + D^6;$$

$$g_1(D) = 1 + D^1 + D^2 + D^3 + D^6;$$

$$g_2(D) = 1 + D^1 + D^2 + D^4 + D^6;$$

or

$$g_3(D) = 1 + D^2 + D^5 + D^6.$$

**13.** The method according to claim 8, wherein a value of a constraint length of the convolutional encoding is 9, and the set of preset component code generator polynomials includes at least one of the following component code generator polynomials:

$$g_0(D) = 1 + D^2 + D^3 + D^4 + D^8;$$

$$g_1(D) = 1 + D^1 + D^2 + D^3 + D^5 + D^7 + D^8;$$

$$g_2(D) = 1 + D^1 + D^2 + D^5 + D^6 + D^8;$$

$$g_3(D) = 1 + D^2 + D^4 + D^7 + D^8;$$

$$g_4(D) = 1 + D^1 + D^2 + D^4 + D^5 + D^6 + D^7 + D^8;$$

$$g_5(D) = 1 + D^3 + D^5 + D^6 + D^8;$$

$$g_6(D) = 1 + D^1 + D^2 + D^3 + D^5 + D^7 + D^8;$$

$$g_7(D) = 1 + D^1 + D^2 + D^3 + D^6 + D^8;$$

$$g_8(D) = 1 + D^1 + D^3 + D^5 + D^6 + D^7 + D^8;$$

$$g_9(D) = 1 + D^1 + D^3 + D^4 + D^5 + D^8;$$

$$g_{10}(D) = 1 + D^1 + D^2 + D^3 + D^6 + D^8;$$

or

$$g_{11}(D) = 1 + D^1 + D^3 + D^5 + D^6 + D^7 + D^8.$$

**14.** The method according to claim 8, wherein a value of a constraint length of the convolutional encoding is 9, and the set of preset component code generator polynomials includes at least one of the following component code generator polynomials:

$$g_0(D) = 1 + D^2 + D^3 + D^5 + D^6 + D^7 + D^8;$$

$$g_1(D) = 1 + D^1 + D^3 + D^4 + D^7 + D^8;$$

$$g_2(D) = 1 + D^1 + D^2 + D^5 + D^8;$$

$$g_3(D) = 1 + D^1 + D^2 + D^3 + D^4 + D^6 + D^8;$$

$$g_4(D) = 1 + D^2 + D^4 + D^5 + D^6 + D^8;$$

$$g_5(D) = 1 + D^2 + D^5 + D^6 + D^7 + D^8;$$

$$g_6(D) = 1 + D^1 + D^3 + D^5 + D^6 + D^7 + D^8;$$

$$g_7(D) = 1 + D^3 + D^4 + D^5 + D^7 + D^8;$$

$$g_8(D) = 1 + D^1 + D^2 + D^3 + D^6 + D^8;$$

$$g_9(D) = 1 + D^1 + D^3 + D^5 + D^6 + D^7 + D^8;$$

$$g_{10}(D) = 1 + D^2 + D^3 + D^5 + D^8;$$

or

$$g_{11}(D) = 1 + D^1 + D^2 + D^3 + D^5 + D^7 + D^8.$$

15. The method according to claim 8, wherein a value of a constraint length of the convolutional encoding is 9, and the set of preset component code generator polynomials includes at least one of the following component code generator polynomials:

$$g_0(D) = 1 + D^3 + D^4 + D^6 + D^8;$$

$$g_1(D) = 1 + D^1 + D^2 + D^3 + D^4 + D^5 + D^8;$$

$$g_2(D) = 1 + D^1 + D^3 + D^4 + D^5 + D^7 + D^8;$$

$$g_3(D) = 1 + D^2 + D^3 + D^6 + D^7 + D^8;$$

$$g_4(D) = 1 + D^2 + D^4 + D^5 + D^6 + D^8;$$

$$g_5(D) = 1 + D^2 + D^5 + D^6 + D^7 + D^8;$$

$$g_6(D) = 1 + D^1 + D^3 + D^5 + D^6 + D^7 + D^8;$$

$$g_7(D) = 1 + D^3 + D^4 + D^5 + D^7 + D^8;$$

$$g_8(D) = 1 + D^2 + D^5 + D^6 + D^7 + D^8;$$

$$g_9(D) = 1 + D^1 + D^2 + D^3 + D^5 + D^7 + D^8;$$

$$g_{10}(D) = 1 + D^3 + D^5 + D^6 + D^8;$$

or

$$g_{11}(D) = 1 + D^1 + D^2 + D^3 + D^5 + D^7 + D^8.$$

16. The method according to claim 1, wherein a value of a constraint length of the convolutional encoding is 9, and the T component code generator polynomials include the following component code generator polynomials:

$$g_0(D) = 1 + D^2 + D^3 + D^5 + D^6 + D^7 + D^8;$$

$$g_1(D) = 1 + D^1 + D^3 + D^4 + D^7 + D^8;$$

$$g_2(D) = 1 + D^1 + D^2 + D^5 + D^8;$$

or

$$g_3(D) = 1 + D^1 + D^2 + D^3 + D^4 + D^6 + D^8.$$

17. The method according to claim 8, wherein a value of a constraint length of the convolutional encoding is 5, and the set of preset component code generator polynomials includes at least one of the following component code generator polynomials:

$$g_0(D) = 1 + D^3 + D^4;$$

$$g_1(D) = 1 + D^1 + D^2 + D^4;$$

$$g_2(D) = 1 + D^2 + D^3 + D^4;$$

$$g_3(D) = 1 + D^1 + D^3 + D^4;$$

$$g_4(D) = 1 + D^1 + D^2 + D^4;$$

$$g_5(D) = 1 + D^2 + D^3 + D^4;$$

$$g_6(D) = 1 + D^1 + D^2 + D^4;$$

$$g_7(D) = 1 + D^2 + D^3 + D^4;$$

$$g_8(D) = 1 + D^1 + D^2 + D^3 + D^4;$$

$$g_9(D) = 1 + D^2 + D^3 + D^4;$$

$$g_{10}(D) = 1 + D^1 + D^2 + D^4;$$

or

$$g_{11}(D) = 1 + D^2 + D^3 + D^4.$$

18. The method according to claim 8, wherein a value of a constraint length of the convolutional encoding is 6, and the set of preset component code generator polynomials includes at least one of the following component code generator polynomials:

$$g_0(D) = 1 + D^2 + D^4 + D^5;$$

$$g_1(D) = 1 + D^1 + D^2 + D^3 + D^5;$$

$$g_2(D) = 1 + D^3 + D^4 + D^5;$$

$$g_3(D) = 1 + D^1 + D^3 + D^4 + D^5;$$

$$g_4(D) = 1 + D^2 + D^3 + D^4 + D^5;$$

$$g_5(D) = 1 + D^1 + D^3 + D^5;$$

$$g_6(D) = 1 + D^1 + D^2 + D^3 + D^5;$$

$$g_7(D) = 1 + D^1 + D^2 + D^5;$$

$$g_8(D) = 1 + D^2 + D^4 + D^5;$$

$$g_9(D) = 1 + D^2 + D^3 + D^4 + D^5;$$

$$g_{10}(D) = 1 + D^1 + D^2 + D^3 + D^5;$$

or

$$g_{11}(D) = 1 + D^1 + D^3 + D^4 + D^5.$$

**19.** The method according to claim 8, wherein a value of a constraint length of the convolutional encoding is 8, and the set of preset component code generator polynomials includes at least one of the following component code generator polynomials:

$$g_0(D) = 1 + D^2 + D^4 + D^5 + D^7;$$

$$g_1(D) = 1 + D^1 + D^2 + D^3 + D^6 + D^7;$$

$$g_2(D) = 1 + D^3 + D^5 + D^6 + D^7;$$

$$g_3(D) = 1 + D^1 + D^3 + D^4 + D^5 + D^6 + D^7;$$

$$g_4(D) = 1 + D^1 + D^2 + D^4 + D^7;$$

$$g_5(D) = 1 + D^2 + D^3 + D^4 + D^5 + D^7;$$

$$g_6(D) = 1 + D^1 + D^2 + D^4 + D^6 + D^7;$$

$$g_7(D) = 1 + D^2 + D^5 + D^6 + D^7;$$

$$g_8(D) = 1 + D^1 + D^3 + D^5 + D^6 + D^7;$$

$$g_9(D) = 1 + D^1 + D^2 + D^5 + D^7;$$

$$g_{10}(D) = 1 + D^1 + D^2 + D^3 + D^4 + D^6 + D^7;$$

or

$$g_{11}(D) = 1 + D^2 + D^5 + D^6 + D^7.$$

**20.** The method according to claim 8, wherein a value of a constraint length of the convolutional encoding is 10, and the set of preset component code generator polynomials includes at least one of the following component code generator polynomials:

$$g_0(D) = 1 + D^1 + D^3 + D^5 + D^6 + D^8 + D^9;$$

$$g_1(D) = 1 + D^2 + D^3 + D^4 + D^5 + D^6 + D^9;$$

$$g_2(D) = 1 + D^2 + D^6 + D^7 + D^8 + D^9;$$

$$g_3(D) = 1 + D^1 + D^2 + D^4 + D^7 + D^8 + D^9;$$

$$g_4(D) = 1 + D^3 + D^5 + D^6 + D^7 + D^9;$$

$$g_5(D) = 1 + D^1 + D^2 + D^3 + D^5 + D^6 + D^9;$$

$$g_6(D) = 1 + D^1 + D^3 + D^5 + D^7 + D^8 + D^9;$$

$$g_7(D) = 1 + D^2 + D^5 + D^6 + D^7 + D^8 + D^9;$$

$$g_8(D) = 1 + D^1 + D^3 + D^4 + D^7 + D^9;$$

$$g_9(D) = 1 + D^1 + D^2 + D^3 + D^4 + D^6 + D^8 + D^9;$$

$$g_{10}(D) = 1 + D^1 + D^3 + D^4 + D^5 + D^6 + D^9;$$

or

$$g_{11}(D) = 1 + D^3 + D^5 + D^6 + D^7 + D^9.$$

**21.** The method according to claim 8, wherein a value of a constraint length of the convolutional encoding is 11, and the set of preset component code generator polynomials includes at least one of the following component code generator polynomials:

$$g_0(D) = 1 + D^3 + D^5 + D^6 + D^7 + D^{10};$$

$$g_1(D) = 1 + D^1 + D^3 + D^4 + D^5 + D^6 + D^{10};$$

$$g_2(D) = 1 + D^1 + D^2 + D^4 + D^5 + D^6 + D^8 + D^{10};$$

$$g_3(D) = 1 + D^1 + D^4 + D^5 + D^6 + D^7 + D^9 + D^{10};$$

$$g_4(D) = 1 + D^2 + D^4 + D^7 + D^8 + D^9 + D^{10};$$

$$g_5(D) = 1 + D^2 + D^3 + D^4 + D^5 + D^7 + D^8 + D^{10};$$

$$g_6(D) = 1 + D^3 + D^4 + D^5 + D^7 + D^9 + D^{10};$$

$$g_7(D) = 1 + D^1 + D^3 + D^4 + D^5 + D^6 + D^7 + D^{10};$$

$$g_8(D) = 1 + D^2 + D^5 + D^6 + D^8 + D^9 + D^{10};$$

$$g_9(D) = 1 + D^2 + D^4 + D^7 + D^8 + D^9 + D^{10};$$

$$g_{10}(D) = 1 + D^1 + D^2 + D^3 + D^4 + D^6 + D^7 + D^{10};$$

or

$$g_{11}(D) = 1 + D^1 + D^2 + D^3 + D^5 + D^7 + D^9 + D^{10}.$$

22. The method according to any one of claims 9, 10, 11, 13, 14, 15, 17, 18, 19, 20 and 21, wherein the T component code generator polynomials at least include first J component code generator polynomials in the set of preset component code generator polynomials; wherein a value of J includes 2, 3, 4, 5, 6, 7, 8, 9 or 10, and J is an integer less than or equal to T.

23. The method according to claim 1, wherein the performing, according to the T component code generator polynomials, convolutional encoding on the information bit sequence, to obtain the encoded bit sequence, comprises:

   performing, according to the T component code generator polynomials, convolutional encoding on the information bit sequence, to obtain T component code bit sequences obtained by the T component code generator polynomials; and
   performing an interleaving process on all or some of the T component code bit sequences, so as to obtain the encoded bit sequence.

24. The method according to claim 1, wherein the performing, according to the T component code generator polynomials, convolutional encoding on the information bit sequence, to obtain the encoded bit sequence, comprises:

   performing, according to the T component code generator polynomials, convolutional encoding on the information bit sequence, to obtain T component code bit sequences obtained by the T component code generator polynomials;
   performing sub-block interleaving on an i-th component code bit sequence to obtain a sub-block interleaved output sequence, i being a non-negative integer less than T; and
   determining the encoded bit sequence according to the sub-block interleaved output sequence and other component code bit sequences among the T component code bit sequences except the i-th component code bit sequence.

25. The method according to claim 24, wherein a value of i is determined according to one or more of: a number of component codes, a coding rate, a total number of transmitted bits, a number of resources, a modulation order, and a length of the information bit sequence.

26. A decoding method, comprising:

   receiving all or some of bits in an encoded bit sequence; and
   performing, according to T component code generator polynomials, convolutional decoding on the all or some of the bits in the encoded bit sequence to obtain an information bit sequence.

27. The method according to claim 26, further comprising:

receiving information related to the encoded bit sequence.

28. The method according to claim 26, wherein the convolutional decoding is achieved according to Viterbi decoding or cyclic redundancy check (CRC)-assisted Viterbi list decoding.

29. A communication apparatus, comprising: a memory and a processor; wherein the memory is coupled to the processor; the memory is configured to store instructions executable by the processor; and the processor, upon executing the instructions, performs the method according to any one of claims 1 to 28.

30. A computer-readable storage medium, wherein the computer-readable storage medium has stored computer instructions that, upon being run on a communication apparatus, enable the communication apparatus to perform the method according to any one of claims 1 to 28.

100 ⟶

FIG. 1

| Acquire an information bit sequence | S101 |

| Generate a polynomial according to T component codes to perform convolutional encoding on the information bit sequence to obtain an encoded bit sequence | S102 |

| Send all or some of the bits in the encoded bit sequence | S103 |

FIG. 2

$c_k^{(0)} g_0 = 133(octal)$

$c_k^{(1)} g_1 = 171(octal)$

$c_k^{(2)} g_2 = 165(octal)$

$c_k^{(3)} g_3 = 123(octal)$

FIG. 3

FIG. 4

Receive all or some of bits in an encoded bit sequence ⟨ S201

Perform convolutional decoding on the all or some of the bits in the encoded bit sequence according to T component code generator polynomials, so as to obtain an information bit sequence ⟨ S202

FIG. 5

Encoding device 60

Acquiring module 601

Processing module 602

Sending module 603

FIG. 6

Decoding device 70

Receiving
module
701

Processing
module
702

FIG. 7

800

Processor
802

Communication
interface
803

Bus
804

Memory
801

FIG. 8

## INTERNATIONAL SEARCH REPORT

| International application No. |
|---|
| **PCT/CN2024/076003** |

**A. CLASSIFICATION OF SUBJECT MATTER**

H04L1/00(2006.01)i

According to International Patent Classification (IPC) or to both national classification and IPC

**B. FIELDS SEARCHED**

Minimum documentation searched (classification system followed by classification symbols)

IPC: H04L, H04W

Documentation searched other than minimum documentation to the extent that such documents are included in the fields searched

Electronic data base consulted during the international search (name of data base and, where practicable, search terms used)

CNTXT, ENTXT, CNKI, VEN, IEEE, 3GPP: 多项式, 分量码, 卷积, 编码, 约束长度, 信息, 比特, 序列, 移位, 异或, polynomial, component code, convolution, encoding, constraint length, information, bit, sequence, shift, xor

**C. DOCUMENTS CONSIDERED TO BE RELEVANT**

| Category* | Citation of document, with indication, where appropriate, of the relevant passages | Relevant to claim No. |
|---|---|---|
| X | CN 101989887 A (TSINGHUA UNIVERSITY) 23 March 2011 (2011-03-23) description, paragraphs [0138]-[0209] | 1-5, 26, 29, 30 |
| A | CN 102111163 A (ZTE CORP.) 29 June 2011 (2011-06-29) entire document | 1-30 |
| A | CN 113472363 A (HUAWEI TECHNOLOGIES CO., LTD.) 01 October 2021 (2021-10-01) entire document | 1-30 |
| A | CN 113872615 A (THE 54TH RESEARCH INSTITUTE OF CHINA ELECTRONICS TECHNOLOGY GROUP) 31 December 2021 (2021-12-31) entire document | 1-30 |
| A | US 2010293432 A1 (MIYATA YOSHIKUN et al.) 18 November 2010 (2010-11-18) entire document | 1-30 |

☐ Further documents are listed in the continuation of Box C.　　☑ See patent family annex.

| | | | |
|---|---|---|---|
| \* | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **24 March 2024** | **24 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/076003**

| Patent document cited in search report | | | Publication date (day/month/year) | Patent family member(s) | | | Publication date (day/month/year) |
|---|---|---|---|---|---|---|---|
| CN | 101989887 | A | 23 March 2011 | None | | | |
| CN | 102111163 | A | 29 June 2011 | None | | | |
| CN | 113472363 | A | 01 October 2021 | None | | | |
| CN | 113872615 | A | 31 December 2021 | None | | | |
| US | 2010293432 | A1 | 18 November 2010 | JP | 2010268114 | A | 25 November 2010 |
| | | | | JP | 5881930 | B2 | 09 March 2016 |
| | | | | US | 8977927 | B2 | 10 March 2015 |
| | | | | EP | 2251983 | A2 | 17 November 2010 |
| | | | | EP | 2251983 | A3 | 12 March 2014 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310583794